(19) Europäisches Patentamt
European Patent Office
Office européen des brevets

(11) **EP 2 650 342 A1**

(12) **EUROPEAN PATENT APPLICATION**
published in accordance with Art. 153(4) EPC

(43) Date of publication:
**16.10.2013 Bulletin 2013/42**

(51) Int Cl.:
*C09K 11/06* (2006.01)          *C08K 5/00* (2006.01)
*C08L 33/06* (2006.01)          *H01L 31/042* (2006.01)

(21) Application number: **11847410.5**

(22) Date of filing: **18.11.2011**

(86) International application number:
**PCT/JP2011/076708**

(87) International publication number:
**WO 2012/077485 (14.06.2012 Gazette 2012/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **06.12.2010 JP 2010271386**

(71) Applicant: **Hitachi Chemical Company, Ltd. Ibaraki 300-4247 (JP)**

(72) Inventors:
• **OKANIWA, Kaoru**
  **Tsukuba-shi**
  **Ibaraki 300-4247 (JP)**

• **YAMASHITA, Takeshi**
  **Tsukuba-shi**
  **Ibaraki 300-4247 (JP)**
• **SAWAKI, Taku**
  **Tsukuba-shi**
  **Ibaraki 300-4247 (JP)**

(74) Representative: **Albrecht, Thomas et al**
  **Kraus & Weisert**
  **Patent- und Rechtsanwälte**
  **Thomas-Wimmer-Ring 15**
  **80539 München (DE)**

(54) **SPHERICAL PHOSPHOR, SEALING MATERIAL FOR WAVELENGTH-CONVERSION-TYPE SOLAR BATTERIES, SOLAR BATTERY MODULE, AND PROCESS FOR MANUFACTURE OF THOSE**

(57)    A spherical phosphor includes a fluorescent substance having a maximum excitation wavelength of 400 nm or longer; and a transparent material containing the fluorescent substance, in which, in an excitation spectrum, an excitation spectral intensity in a wavelength region of from 340 nm to 380 nm is 50% or higher of an excitation spectral intensity at a maximum excitation wavelength. A wavelength conversion-type photovoltaic cell sealing material includes a light-permeable resin composition layer that contains the spherical phosphor and a sealing resin.

FIG. 4

## Description

Technical Field

The present invention relates to a spherical phosphor, a wavelength conversion-type photovoltaic cell sealing material, a photovoltaic cell module, and methods of producing them.

Background Art

Conventional crystalline silicon photovoltaic cell modules are configured as follows. As a surface protective glass (also referred to as "cover glass"), a tempered glass is used in consideration of the shock resistance. In order to improve the adhesion with a sealing material (usually, a resin including an ethylene vinyl acetate copolymer as a major component; also referred to as "filler"), one surface of the protective glass is embossed to have an asperity pattern.
In addition, the asperity pattern is formed inside, and the surface of the photovoltaic cell module is smooth. Furthermore, a sealing material for protecting and sealing a photovoltaic cell element and tab lines, and a back film are provided under the protective glass

In general, in the solar spectrum, light in a short wavelength region of 360 nm or shorter and light in a long wavelength region of 1200 nm or longer do not contribute to the power generation in a crystalline silicon photovoltaic cell. Such a phenomenon is called spectral mismatch. With regard to this phenomenon, for example, Japanese Patent Application Laid-Open (JP-A) No. 2003-218379 proposes a method of providing a layer which emits light in a wavelength region capable of contributing to power generation, on a light receiving surface of a photovoltaic cell, in which the wavelength of light in the ultraviolet or infrared region, which does not contribute to power generation, of the solar spectrum is converted by a fluorescent substance (also referred to as "light emitting material").

In addition, JP-A No. 2006-303033 proposes a method of adding a rare earth metal complex which is a fluorescent substance into a sealing material.
Furthermore, for example, as disclosed in JP-A No. 2003-051605, thermosetting ethylene-vinyl acetate copolymers have been widely used conventionally as transparent sealing materials for photovoltaic cells.

DISCLOSURE OF INVENTION

Technical Problem

In the proposal of JP-A No. 2003-218379, light which does not contribute to power generation is converted into light having a wavelength capable of contributing to power generation, and a wavelength conversion layer contains the fluorescent substance. However, since this fluorescent substance generally has large dimensions, there are cases in which the amount of incident sunlight which reaches the photovoltaic cell element is insufficient when passing through the wavelength conversion film, and the proportion of light not contributing to power generation increases. As a result, there is a problem in that, even when the wavelength conversion layer converts light in the ultraviolet region into light in the visible range, a ratio of generated power to incident sunlight (power generation efficiency) is sometimes not as high as would be expected. Furthermore, there are cases in which power generation efficiency deteriorates due to absorption or scattering loss caused by the fluorescent substance, as compared to a case in which the fluorescent substance is not introduced.

In addition, in the method disclosed in JP-A No. 2003-051605, there are cases in which a rare earth complex used as the fluorescent substance is easily hydrolyzed together with ethylene vinyl acetate (EVA), which is widely used as a sealing material, which may result in deterioration over time. In addition, because of the configuration thereof, it is difficult to introduce wavelength-converted light into a photovoltaic cell element. Furthermore, when the rare earth complex as the fluorescent substance is dispersed in EVA, there are cases in which an acid is produced due to the hydrolysis of the EVA, hydrolysis of the rare earth metal complex is induced, fluorescence is not emitted, and the desired wavelength conversion effect is not obtained. Furthermore, molecules of the rare earth metal complex are likely to aggregate, and the aggregates scatter the excitation wavelength. Therefore, there is a problem in that the utilization efficiency of the rare earth metal as a phosphor may further deteriorate.

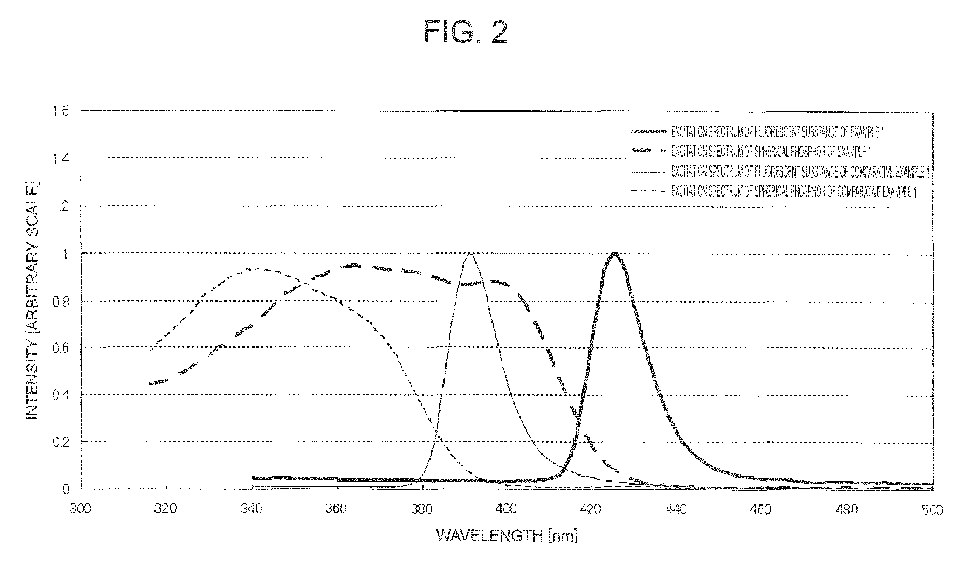

In order to obtain a desired wavelength conversion effect, a europium complex which absorbs ultraviolet rays and emits red fluorescence is one of the most effective fluorescent substances. For example, in the case of Eu (TTA)$_3$Phen which is a representative complex, the excitation wavelength of the complex alone has an excitation end at 420 nm as illustrated in Fig. 2. However, the excitation wavelength may vary depending on the state of the complex and, in particular, the sealing method. For example, in the case of a resin sealing material, there is an excitation band in a shorter wavelength region than 400 nm. When there is an excitation band in such a wavelength range, excitation is caused by light of a wavelength having a weak intensity in the solar spectrum, leading to reduction of fluorescence intensity.

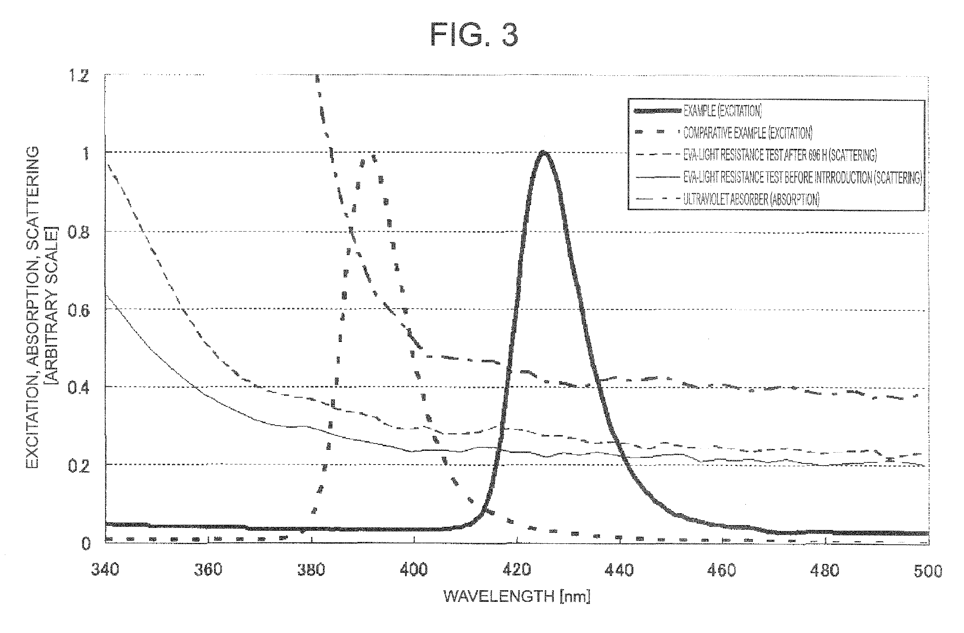

Furthermore, EVA, which is a representative sealing material, deteriorates as illustrated in Fig. 3 when irradiated with ultraviolet rays. In particular, scattering loss increases in a shorter wavelength region than 400 nm. While the sensitivity of a crystalline silicon photovoltaic cell element is not significantly damaged by this scattering loss, the wavelength conversion effect, which is an object of the present invention, is greatly affected. In order to reduce this kind of light deterioration of EVA, an ultraviolet absorber is generally added to EVA. As illustrated in Fig. 3, the absorption spectrum of the ultraviolet absorber overlaps the excitation wavelength of a normal europium complex such as Eu (TTA)$_3$Phen. Therefore, the excitation of the europium complex may be inhibited in some cases. Meanwhile, in order to obtain a satisfactory wavelength conversion effect, the amount of the ultraviolet absorber to be added should be reduced. Accordingly, there is a problem in that the light deterioration of EVA and the addition of an ultraviolet absorbent as a countermeasure have a trade-off relationship with each other as long as a normal europium complex such as Eu (TTA)$_3$Phen is used.

The present invention has been made in order to address the above-described problems. Objects of the present invention are to provide a spherical phosphor which is capable of improving the light utilization efficiency of a photovoltaic cell module and stably improving the power generation efficiency, a wavelength conversion-type photovoltaic cell sealing material, a photovoltaic cell module, and methods of producing the same.

Solution to Problem

As a result of extensive research with a view to addressing these problems, the inventors of the present invention have found that, among sunlight rays, the wavelength of light which does not contribute to photovoltaic power generation can be converted into a wavelength which contributes to power generation by using a spherical phosphor which contains a fluorescent substance having an excitation band in a specific wavelength. Furthermore, the inventors have found that the spherical phosphor has superior light resistance, humidity resistance, heat resistance, and dispersibility and is capable of efficiently guiding incident sunlight into a photovoltaic cell element without being scattered by the fluorescent substance, thereby completing the present invention. Furthermore, in particular, when an organic rare earth metal complex is used as the fluorescent substance of the spherical phosphor, the resistance of the fluorescent substance to humidity is further improved.

In particular, the inventors have found a method of obtaining a spherical phosphor having high transparency and high luminous efficiency by sealing, as the spherical phosphor, a fluorescent substance having an excitation band in a specific wavelength, thereby completing the present invention.

That is, aspects of the invention are as follows.
<1> A spherical phosphor including:

a fluorescent substance having a maximum excitation wavelength of 400 nm or longer; and
a transparent material containing the fluorescent substance,
in which in an excitation spectrum, an excitation spectral intensity in a wavelength region of 340 nm to 380 nm is 50% or higher of an excitation spectral intensity at a maximum excitation wavelength.

<2> The spherical phosphor according to <1>, in which the fluorescent substance is a rare earth metal complex.

<3> The spherical phosphor according to < 1> or <2>,
in which the fluorescent substance is a europium complex.

<4> The spherical phosphor according to any one of <1> to <3>,
in which the transparent material is a transparent resin.

<5> The spherical phosphor according to any one of <1> to <4>,
in which the transparent material is a transparent vinyl resin.

<6> The spherical phosphor according to any one of <1> to <5>,
in which the transparent material is a (meth)acrylic resin.

<7> The spherical phosphor according to any one of <1> to <6>,
in which a refractive index of the transparent material is greater than or equal to 1.4 and less than a refractive index of the fluorescent substance.

<8> The spherical phosphor according to any one of <5> to <7>, which is an emulsion polymer or a suspension polymer of a vinyl monomer composition containing the fluorescent substance and a vinyl monomer.

<9> The spherical phosphor according to any one of <5> to <8>, which is a suspension polymer of a vinyl monomer composition containing the fluorescent substance and a vinyl monomer.

<10> A wavelength conversion-type photovoltaic cell sealing material including:

a light-permeable resin composition layer that contains the spherical phosphor according to any one of <1> to <9> and a sealing resin.

<11> The wavelength conversion-type photovoltaic cell sealing material according to <10>,
in which a content of the spherical phosphor in the resin composition layer is 0.0001% by mass to 10% by mass.

<12> The wavelength conversion-type photovoltaic cell sealing material according to <10> or <11>, further including:

a light-permeable layer other than the resin composition layer.

<13> The wavelength conversion-type photovoltaic cell sealing material according to <12>, including:

the resin composition layer; and
a number, m, of light-permeable layers other than the resin composition layer,
in which when respective refractive indices of the m layers are represented by $n_1$, $n_2$, ..., $n_{(m-1)}$, and $n_m$ in order from a light incident side, an expression of

$n_1 \leq n_2 \leq ...n_{(m-1)} \leq n_m$ is sati sfied.

<14> A photovoltaic cell module including:

a photovoltaic cell element; and
the wavelength conversion-type photovoltaic cell sealing material according to any one of <10> to <13>, disposed on a light receiving surface of the photovoltaic cell element.

<15> A method of manufacturing the wavelength conversion-type photovoltaic cell sealing material according to any one of <10> to <13>, the method including:

preparing the spherical phosphor according to any one of <1> to <9>;
mixing or dispersing the spherical phosphor with or in a sealing resin to prepare a resin composition; and
forming the resin composition into a sheet form to prepare a light-permeable resin composition layer.

<16> A method of manufacturing a photovoltaic cell module including:

preparing the wavelength conversion-type photovoltaic cell sealing material according to any one of <10> to <13>; and
disposing the wavelength conversion-type photovoltaic cell sealing material on a light receiving surface of a photovoltaic cell element.

Advantageous Effects of Invention

According to the present invention, it is possible to provide a spherical phosphor which is capable of improving the light utilization efficiency of a photovoltaic cell module and stably improving the power generation efficiency, a wavelength conversion-type photovoltaic cell sealing material, a photovoltaic cell module, and methods of producing them.

BRIEF DESCRIPTION OF DRAWINGS

Fig. 1 is a diagram illustrating examples of a solar spectrum and a spectral sensitivity of a crystalline silicon photovoltaic cell.
Fig. 2 is a diagram illustrating exemplary excitation spectra of a fluorescent substance according to an example of the present invention and a spherical phosphor containing the fluorescent substance.
Fig. 3 is a diagram illustrating examples of a spectrum relating to light deterioration of EVA, an excitation spectrum of a fluorescent substance according to an example of the present invention, and an absorption spectrum of an ultraviolet absorber.

Fig. 4 is a diagram illustrating examples of a solar spectrum, a spectral sensitivity of a crystalline silicon photovoltaic cell, scattering spectra before and after light deterioration of EVA, a spectnun of an ultraviolet absorber, an excitation spectrum of a fluorescent substance of the related art, and an excitation spectrum of a fluorescent substance according to an example of the present invention are shown.
Fig. 5 is a schematic diagram illustrating an example of the refraction of light at an interface having different refractive indices.
Fig. 6 is a schematic diagram illustrating an example of the wavelength dependence of a refractive index.
Fig. 7 is a schematic diagram illustrating an example of a relationship between a spherical phosphor according to an example of the present invention and incident light rays.
Fig. 8 is a diagram illustrating examples of an excitation spectrum and an absorption spectrum of a fluorescent substance according to an example of the present invention in the solution state.
Fig. 9 is a cross-sectional view schematically illustrating the configuration of a wavelength conversion-type photovoltaic cell sealing material having a two-layer structure.
Fig. 10 is a diagram illustrating examples of the light resistance of photovoltaic cell modules according to an example of the present invention and according to a comparative example.

BEST MODE FOR CARRYING OUT THE INVENTION

<Spherical Phosphor>

A spherical phosphor according to the present invention is configured to include: a fluorescent substance having a maximum excitation wavelength of 400 nm or longer; and a transparent material containing the fluorescent substance. In an excitation spectrum thereof, an excitation spectral intensity in a wavelength region of 340 nm to 380 nm is 50% or higher of an excitation spectral intensity at a maximum excitation wavelength of the spherical phosphor.
It is possible to improve the light utilization efficiency and to stably improve the power generation efficiency by configuring a photovoltaic cell module using a wavelength conversion-type photovoltaic cell sealing material which contains such a spherical phosphor having an excitation band in the specific wavelength.
The spherical phosphor having an excitation band in the specific wavelength is contained, for example, in a wavelength-converting resin composition layer that is a component of a wavelength conversion-type photovoltaic cell sealing material. For example, in a crystalline photovoltaic cell, among sunlight rays, light in a shorter wavelength region than 400 nm and light in a longer wavelength region than 1200 nm are not efficiently used. Therefore, approximately 56% of solar energy does not contribute to power generation due to this spectral mismatch. According to the present invention, a phosphor having excellent light resistance, humidity resistance, heat resistance, and dispersibility and having a specific shape in which concentration quenching is suppressed, is used. As a result, sunlight can be efficiently and stably used by wavelength conversion, thereby solving the spectral mismatch. Furthermore, the utilization efficiency of a rare earth metal complex as the fluorescent substance is increased to the maximum, whereby the effective luminous efficiency is enhanced. Therefore, it is possible to use an expensive rare earth complex to contribute to power generation while suppressing the amount thereof to the minimum.

That is, the spherical phosphor of the present invention having an excitation band in a specific wavelength is a fluorescent substance which has excellent light resistance, humidity resistance, heat resistance, and dispersibility, and in which concentration quenching is suppressed. By using such a fluorescent substance, the utilization efficiency of a rare earth metal complex, which is an expensive fluorescent substance, can be increased to the maximum. Furthermore, by improving the effective luminous efficiency, the power generation efficiency of a photovoltaic cell module can be improved. In addition, the spherical phosphor according to the present invention in which a fluorescent substance having an excitation band in a specific wavelength is used, and a wavelength conversion-type photovoltaic cell sealing material using the spherical phosphor, enable conversion of light that does not contribute to photovoltaic power generation into a wavelength that contributes to power generation, among incident sunlight, and suppression of scattering of the light, whereby the light is efficiently introduced into a photovoltaic cell element.

From the viewpoint of photovoltaic power generation, the spherical phosphor encloses a fluorescent substance contained in the spherical phosphor having a maximum excitation wavelength of 400 nm or longer, in which, in the excitation spectrum of the spherical phosphor, the excitation spectral intensity in the entire wavelength region of from 340 nm to 380 nm is 50% or higher of the excitation spectral intensity of the maximum excitation wavelength of the spherical phosphor. Furthermore, it is preferable that the excitation spectral intensity in the entire wavelength region of from 340 nm to 390 nm be 50% or higher of the excitation spectral intensity of the maximum excitation wavelength of the spherical phosphor. It is more preferable that the excitation spectral intensity in the entire wavelength region of from 340 nm to 400 nm be 50% or higher of the excitation spectral intensity of the maximum excitation wavelength of the spherical phosphor.

The maximum excitation wavelength of the fluorescent substance is measured at room temperature (25°C) after the fluorescent substance is put into a solution state. The maximum excitation wavelength of the fluorescent substance is measured with a fluorescence spectrophotometer (for example, a fluorescent spectrophotometer F-4500 manufactured by Hitachi High-Technologies Corporation) using dimethylformamide as a solvent. The excitation spectrum of the spherical phosphor is measured using a fluorescence spectrophotometer at room temperature (25°C) in a state in which the spherical phosphor is interposed between two glass plates.

The excitation spectrum of the spherical phosphor is different from the excitation spectrum in the solution state of the fluorescent substance to be enclosed in the spherical phosphor. Specifically, as illustrated in Fig. 2, the excitation spectrum of the spherical phosphor has a wide excitation wavelength band in a shorter wavelength region than the maximum excitation wavelength of the fluorescent substance in the solution state. The reason for this might be thought to be, for example, that the fluorescent substance is enclosed in the transparent material.

According to the present invention, the excitation spectrum of the spherical phosphor has an excitation wavelength band in the wavelength region of from 340 nm to 380 nm, and the excitation spectral intensity in the entire excitation wavelength band is 50% or higher of the excitation spectral intensity at the maximum excitation wavelength of the spherical phosphor itself. As a result, sunlight rays can be more efficiently used for photovoltaic power generation.

The description thereof will be given with reference to the drawings.

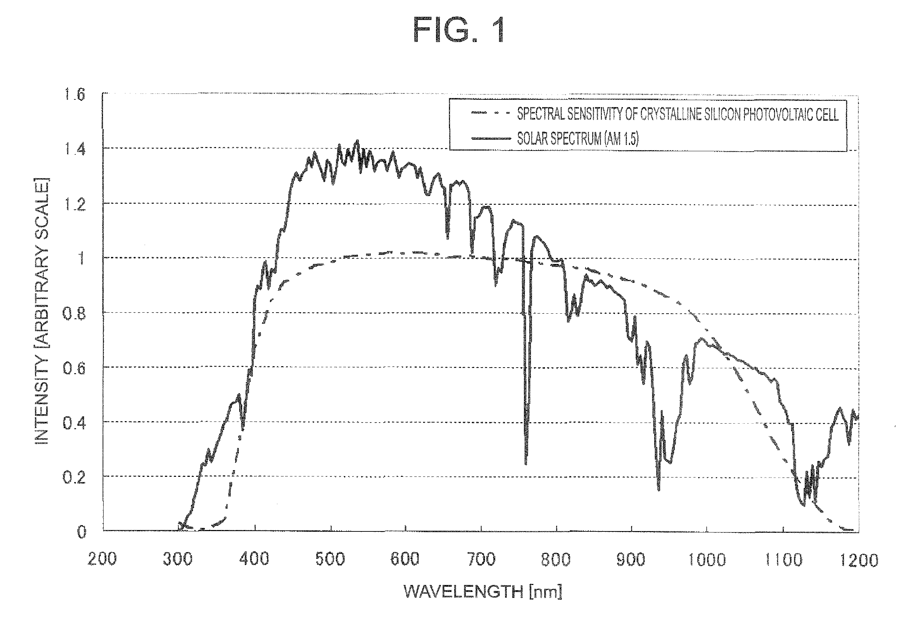

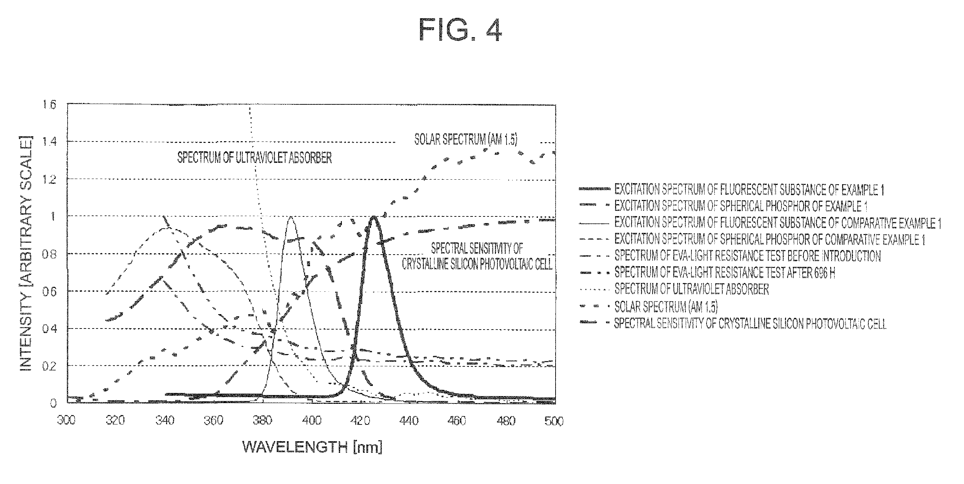

FIG. 1 illustrates examples of a solar spectrum and a spectral sensitivity of a crystalline silicon photovoltaic cell. FIG. 4 illustrates an example of scattering spectra before and after light deterioration of EVA which is an example of a sealing resin described below, an example of an absorption spectrum of a general ultraviolet absorber, an example of excitation spectra in the solution state of fluorescent substances according to Example 1 and Comparative Example 1 described below, and an example of excitation spectra of spherical phosphors according to Example 1 and Comparative Example 1.

As illustrated in FIG. 1, in the solar spectrum, the intensity appears from 300 nm, is maximum at around 450 nm, and is gradually reduced as the wavelength becomes longer. In the spectral sensitivity of the crystalline silicon photovoltaic cell, the sensitivity is gradually increased from approximately 350 nm to a longer wavelength and is maximum at 500 nm.

In a wavelength conversion technique, it is preferable to use a spherical phosphor which has an intensity in the solar spectrum, is excited in a wavelength region having a low sensitivity of the crystalline silicon photovoltaic cell, and has a fluorescence intensity at 500 nm to 800 nm where the sensitivity of the crystalline silicon photovoltaic cell is satisfactory high. When the excitation wavelength of the spherical phosphor is longer than 500 nm, the spherical phosphor may absorb light in a wavelength region in which the crystalline silicon photovoltaic cell is capable of generating power with a sufficient sensitivity as expected. Therefore, in this case, unless the fluorescence quantum efficiency is "1" or higher as in the case of two-photon emission or the like, the wavelength conversion effect is not substantially obtained. Thus, the fluorescent substance usable in the spherical phosphor is limited. Furthermore, actually, no material having a fluorescence quantum efficiency of 1 or higher in this wavelength has yet been found.

Practically, a material which undergoes the one- photon process is used for both excitation and fluorescence emission. However, an organic phosphor such as Rhodamine 6G, Rhodamine B, or coumarin has a small difference between the excitation wavelength and the fluorescence wavelength, that is, has a small Stokes shift. Accordingly, in order to obtain a fluorescence wavelength which is effective for wavelength conversion, the crystalline silicon photovoltaic cell should absorb not a little amount of light in a wavelength region, capable of generating power with a sufficient sensitivity. Therefore, there are cases in which the wavelength conversion effect is not sufficiently obtained. Furthermore, since a general organic phosphor has low fluorescence quantum efficiency, there are cases in which the wavelength conversion effect is not sufficiently obtained.

On the other hand, in the rare earth metal complex, an organic ligand absorbs light, the energy thereof is transferred to a central metal, and fluorescence emission from a rare earth metal as the central metal is utilized. Therefore, in the rare earth metal complex, the excitation wavelength depends on the organic ligand, and the fluorescence wavelength substantially depends on the used metal. Accordingly, it is possible to make the Stokes shift large, and enhance the fluorescence quantum efficiency.

In this way, in the rare earth metal complex, while there is a degree of freedom for the selection of the excitation wavelength, depending on the molecular design of the organic ligand, the fluorescence wavelength is substantially fixed. Preferable examples of the central metal of the rare earth metal complex include europium and samarium from the viewpoint of the fluorescence wavelength, and europium is particularly preferable as a fluorescent substance for wavelength conversion of a crystalline silicon photovoltaic cell.

In FIG. 4, the excitation spectrum of the fluorescent substance alone used in Example 1 in a dimethylformamide solution, the excitation spectrum of a spherical phosphor in which the fluorescent substance is dispersed and enclosed in a transparent material, and the spectral sensitivity curve of the crystalline silicon photovoltaic cell element are shown. It can be seen than, when the fluorescent substance is enclosed in the spherical phosphor, the maximum excitation wavelength of the fluorescent substance in a solution is shifted to a shorter wavelength side and is broadened (widened). The excitation spectrum of the spherical phosphor intersects with the spectral sensitivity curve of the crystalline silicon photovoltaic cell element at around 410 nm. In addition, it can be seen that the fluorescence spectral intensity at around 410 nm is approximately 70% of the fluorescence spectral intensity at the maximum excitation wavelength of the fluorescent substance in the solution.

On the other hand, the fluorescence spectrum of the spherical phosphor according to Comparative Example 1 in which the fluorescent substance is enclosed in the transparent material is also shifted to a shorter wavelength side as in the case of Example 1, and intersects with the spectral sensitivity curve of the crystalline silicon photovoltaic cell element at around 380 nm with an intensity of approximately 30%.

Furthermore, in FIG. 4, the absorption spectrum of a representative ultraviolet absorber is also shown. The ultraviolet absorber shows absorption in the ultraviolet region, and the absorption intensity thereof is rapidly reduced at from 380 nm to 400 nm. The absorption spectrum thereof overlaps the excitation wavelength band of the spherical phosphor according to Comparative Example 1 and further partially overlaps the excitation spectrum of the fluorescent substance alone.

On the other hand, the spherical phosphor according to Example 1 has a high intensity of the excitation spectrum even in a region out of the absorption region of the ultraviolet absorber. Therefore, even when the ultraviolet absorber is used in combination with the wavelength conversion- type photovoltaic cell sealing material, the photovoltaic power generation efficiency is further improved by using such a spherical phosphor according to Example 1.

As illustrated in FIG. 4, the wavelength of EVA which is a representative sealing resin tends to be increasingly scattered as the wavelength becomes shorter, owing to light deterioration. However, by using such a spherical phosphor according to Example 1 having an excitation band in a relatively long wavelength side, the influence of the light deterioration of EVA on the photovoltaic power generation efficiency can be reduced.

In a case of Eu (TTA)$_3$Phen (1, 10- phenanthroline) tris [4, 4, 4- trifluoro- 1- (2- thienyl)- 1, 3- butanedionato] europium (III) ), which is a conventionally well-known europium complex, the excitation wavelength thereof has a peak at 390 nm and is spread out at 380 nm to 420 nm.

In contrast, in a case of a europium complex contained in the spherical phosphor according to an embodiment of the present invention, it is preferable that the excitation wavelength thereof be longer due to the design of the organic ligand. In particular, it is preferable that the fluorescent substance absorb substantially no light rays in a wavelength region in which a crystalline silicon photovoltaic cell can generate power with a sufficient sensitivity as expected, and have an excitation band in a wavelength region having a sufficient intensity in the solar spectrum, specifically, in a wavelength region shorter than 450 nm and longer than 400 nm.

Examples of a method of realizing such an excitation wavelength include methods disclosed in Japanese Patent Application No. 2010-085483 and Japanese Patent Application No. 2010-260326, but the present invention is not limited to these methods.

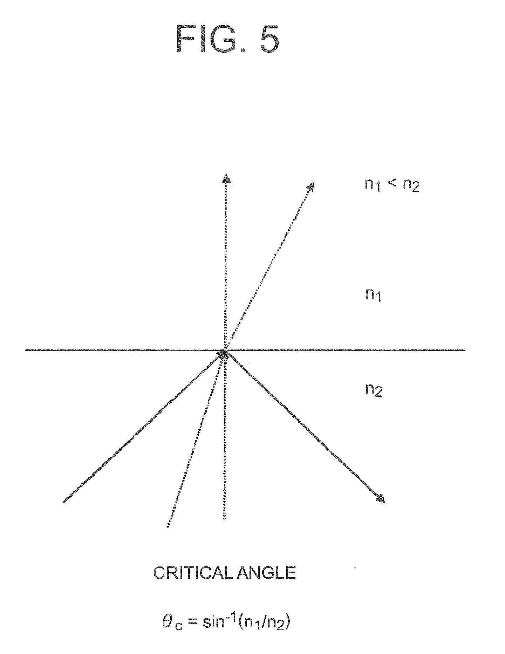

Furthermore, according to the present invention, the fluorescent substance is confined in a spherical body and thus the ability of the fluorescent substance can be exhibited to the maximum. The description thereof will be given with reference to the drawings. As illustrated in Fig. 5, when light advances from a high-refractive medium to a low-refractive medium, total reflection occurs at the interface therebetween depending on a relative refractive index. As representative examples to which this phenomenon is actively applied, there are various optical apparatuses such as an optical fiber, an optical waveguide, or a semiconductor laser. The condition for total reflection is such that the incident angle is greater than the critical angle $\theta_c$ expressed by the following expression.

$$\theta_c = \sin^{-1}(n_1/n_2)$$

Meanwhile, a material has an intrinsic refractive index, which is wavelength-dependent. Therefore, the refractive index of a transparent material also increases from a longer wavelength to a shorter wavelength. In particular, when a material shows absorption in a specific wavelength, the refractive index near the wavelength is large.

Furthermore, in the fluorescent substance, the transition from the ground state to the excitation state occurs in the absorption wavelength (excitation wavelength), and the energy is emitted as fluorescence emission (also referred to as light emission) when the excitation state returns to the ground state. That is, by mixing a fluorescent substance with a transparent material, the refractive index, especially in the excitation wavelength range, may be increased to a higher level than that of the transparent material (for example, a transparent resin) which is the base material.

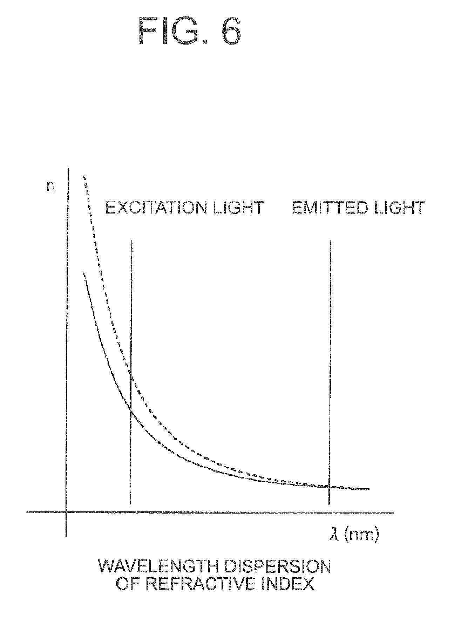

This state is schematically shown in FIG. 6. In the drawing, the solid line indicates the refractive index distribution of a transparent material which is a base material; and the broken line indicates the refractive index distribution when the transparent material contains a fluorescent substance. In particular, with regard to the refractive index, by appropriately selecting the transparent material which is the spherical base material, the fluorescent substance, and a medium (sealing resin), an interrelationship can be obtained in which the refractive index in the spherical body is larger than that of the medium (sealing resin) in the excitation wavelength region and is smaller than that of the medium (sealing resin) in the emission wavelength region as illustrated in FIG. 6.

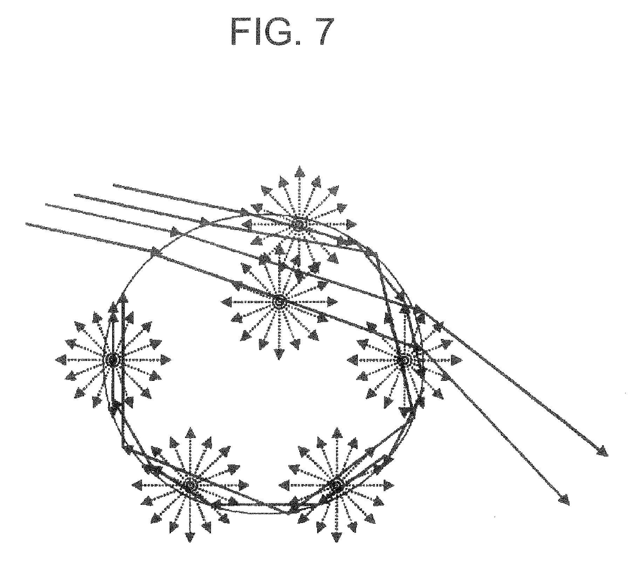

In such a state, the light in the excitation wavelength region easily centers the spherical body which has a high refractive index. In addition, since the refractive index of the sealing resin located outside the spherical body is low, it is difficult for the light to exit from the inside of the spherical body to the outside due to the total reflection in the spherical body and thus the total reflection is repeated in the spherical body. Therefore, it can be considered that the fluorescent substance contained in the spherical body can increase the utilization efficiency of excitation light. On the other hand, in the emission wavelength region, since the difference between the refractive index of the spherical body and the refractive index of the medium (for example, a sealing resin) located outside the spherical body is large, light is easily emitted to the outside of the spherical body. This state is schematically shown in Fig. 7.

In this way, particles containing the fluorescent substance are formed in a spherical shape. As a result, even when an expensive fluorescent substance is used in a small amount, light emission in which the wavelength of a sufficient amount of light rays is converted can be obtained.

In particular, since the fluorescent substance absorbs light in the excitation wavelength, the refractive index in the excitation wavelength region is increased and light scattering is likely to occur. Furthermore, when the fluorescent substance aggregates, light scattering occurs to a large extent, and thus there are cases in which the desired effect of improving the power generation efficiency by the wavelength conversion is not obtained. However, by making the fluorescent substance enclosed in the transparent material (preferably, a transparent material having a lower refractive index than that of the fluorescent substance), light scattering caused by the difference between the refractive indices of the fluorescent substance and the sealing resin can be effectively suppressed.

Furthermore, when a substance having a low humidity resistance such as a rare earth complex is used as the fluorescent substance, the humidity resistance can be improved by making the fluorescent substance confined in the spherical body of the transparent material (preferably, a transparent material having humidity resistance).

The spherical phosphor according to the present invention can be suitably used for a photovoltaic cell module and is also applicable to wavelength conversion-type agricultural materials, various optical apparatuses and display apparatuses using light emitting diode excitation, and various optical apparatuses and display apparatuses using laser excitation. However, the spherical phosphor according to the present invention is not limited to these applications.

The spherical phosphor according to the present invention includes at least one kind of fluorescent substance described below and at least one kind of transparent material, and has a spherical shape. Being a spherical shape described herein represents that the arithmetic mean value of circularity of 100 measurement particles is greater than or equal to 0.90, the circularity being defined by, for example, an analysis software installed on an automated particle shape and particle size image analyzer SYSMEX FPIA-3000 manufactured by Malvern Instruments Ltd. However, in the present invention, the spherical degree is not defmed by the range of circularity.

(Fluorescent Substance)

The fluorescent substance used in the present invention is not limited as long as the maximum excitation wavelength thereof is equal to or longer than 400 nm, and may be appropriately selected according to the purpose. For example, a fluorescent substance having an excitation wavelength of 500 nm or shorter (more preferably 450 nm or shorter) and an emission wavelength longer than the excitation wavelength is preferable; and a compound capable of converting light in a wavelength region in which the utilization efficiency of a general photovoltaic cell is insufficient into light in a wavelength region in which the utilization efficiency of the photovoltaic cell is high.

Specifically, preferable examples of the fluorescent substance include an organic phosphor, an inorganic phosphor, and a rare earth metal complex. Among these, from the viewpoint of wavelength conversion efficiency, at least one of an organic phosphor or a rare earth metal complex is preferable; and a rare earth metal complex is more preferable.

-Inorganic Phosphor-

Examples of the inorganic phosphor include fluorescent particles of $Y_2O_2S$: Eu, Mg, Ti; $Er^{3+}$ ion-containing oxyfluoride crystallized glass; inorganic fluorescent substances such as $SrAl_2O_4$: Eu, Dy or $Sr_4Al_{14}O_{25}$: Eu, Dy, which are obtained by adding a rare earth element such as europium (Eu) or dysprosium (Dy) to a compound formed from strontium oxide and aluminum oxide; and inorganic fluorescent substances such as $CaAl_2O_4$: Eu, Dy and ZnS: Cu.

-Organic Phosphor-

Examples of the organic phosphor include organic dyes such as cyanine dyes, pyridine dyes, or rhodamine dyes; and organic phosphors such as LUMOGEN F Violet 570, Yellow 083, Orange 240, or Red 300 (manufactured by BASF Corporation), basic dyes RHODAMINE B (manufactured by Taoka Chemical Co. Ltd.), SUMIPLAST Yellow FL7G (manufactured by Sumika Fine Chemicals Co., Ltd.), and MACROLEX Fluorescent Red G or Yellow 10GN (manufactured by Bayer Ltd.).

-Rare Earth Metal Complex-

As a metal forming the rare earth metal complex, at least one of europium or samarium is preferable, and europium is more preferable, from the viewpoints of luminous efficiency and emission wavelength.

In addition, a ligand forming the rare earth metal complex is not particularly limited as long as it is capable of being coordinated to a rare earth metal, and may be appropriately selected according to the metal to be used. In particular, from the viewpoint of luminous efficiency, an organic ligand is preferable, and an organic ligand which is capable of being coordinated to at least one of europium or samarium is more preferable.

In the present invention, the ligand is not particularly limited, but it is preferable that the ligand be at least one kind of neutral ligand selected from carboxylic acids, nitrogen- containing organic compounds, nitrogen- containing aromatic heterocyclic compounds, β-diketones, and phosphine oxides.

As the ligand of the rare earth complex, β- diketones represented by the formula of $R^1COCHR^2COR^3$ (wherein $R^1$ represents an aryl group, an alkyl group, a cycloalkyl group, a cycloalkyl- alkyl group, an aralkyl group, or a substituted group thereof; $R^2$ represents a hydrogen atom, an alkyl group, a cycloalkyl group, a cycloalkyl- alkyl group, an aralkyl group, or an aryl group; and $R^3$ represents an aryl group, an alkyl group, a cycloalkyl group, a cycloalkyl- alkyl group, an aralkyl group, or a substituted group thereof) may be contained.

Specific examples of β- diketones include acetylacetone, perfluoroacetylacetone, benzoyl- 2- furanoylmethane, 1, 3- di (3- pyridyl)- 1, 3- propanedione, benzoyltrifluoroacetone, benzoylacetone, 5- chlorosulfonyl- 2- thenoyltrifluoroacetone, bis (4- bromobenzoyl) methane, dibenzoylmethane, d, d- dicampholylmethane, 1, 3- dicyano- 1, 3- propanedione, p- bis (4, 4, 5, 5, 6, 6, 6- heptafluoro- 1, 3- hexanedinoyl) benzene, 4, 4'- dimethoxy dibenzoylmethane, 2, 6- dimethyl- 3, 5- heptanedione, dinaphthoylmethane, dipivaloylmethane, bis (perfluoro- 2- propoxypropionyl) methane, 1.3- di (2- thienyl)- 1, 3- propanedione. 3- (trifluoroacetyl)- d- camphor, 6, 6, 6- trifluoro- 2, 2- dimethyl- 3, 5- hexanedione. 1, 1, 1, 2, 2, 6, 6, 7, 7, 7- decafluoro- 3, 5- heptanedione, 6, 6, 7, 7, 8, 8, 8- heptafluoro- 2, 2- dimehtyl- 3, 5- octanedione, 2- furyltrifluoroacetone, hexafluoroacetylacetone, 3- (heptafluorobutyryl)- d- camphor, 4, 4, 5, 5, 6, 6, 6- heptafluoro- 1- (2- thienyl)- 1, 3- hexanedione, 4- methoxydibenzoylmethane, 4- methoxybenzoyl- 2- furanoylmethane, 6- methyl- 2, 4- heptanedione, 2- naphthoyltrifluoroacetone, 2- (2- pyridyl) benzimidazole, 5, 6- dihydroxy- 1, 10- phenanthroline, 1- phenyl- 3- methyl- 4- benzoyl- 5- pyrazole, 1- phenyl- 3- methyl- 4- (4- butylbenzoyl)- 5- pyrazole, 1- phenyl- 3- methyl- 4- isobutyryl- 5- pyrazole, 1- phenyl- 3- methyl- 4- trifluoroacetyl- 5- pyrazole, 3- (5- phenyl- 1, 3, 4- oxadiazol- 2- yl)- 2, 4- pentanedione, 3- phenyl- 2, 4- pentanedione, 3- [3', 5'- bis (phenylmethoxy) phenyl]- 1- (9- phenanthyl)- 1- propane- 1, 3- dione, 5, 5- dimethyl- 1, 1, 1- trifluoro- 2, 4- hexanedione, 1- phenyl- 3- (2- thienyl)- 1, 3- propanedione, 3- (t- butylhydroxymethylene)- d- camphor, 1, 1, 1- trifluoro- 2, 4- pentanedione, 1, 1, 1, 2, 2, 3, 3, 7, 7, 8, 8,9, 9, 9- tetradecafluoro- 4, 6- nonanedione, 2, 2, 6, 6- tetramethyl- 3, 5- heptanedione, 4, 4, 4- trifluoro- 1- (2- naphthyl)- 1, 3- butanedione, 1, 1, 1- trifluoro- 5, 5- dimethyl- 2, 4- hexanedione, 2, 2, 6, 6- tetramethyl- 3, 5- heptanedione, 2, 2, 6, 6- tetramethyl- 3, 5- octanedione, 2, 2, 6- trimethyl- 3, 5- heptanedione, 2, 2, 7- trimethyl- 3, 5- octanedione, 4, 4, 4- trifluoro- 1- (thienyl)- 1, 3- butanedione (TTA), 1- (p- t- butylphenyl)- 3- (N- methyl- 3- pyrrole)- 1, 3- propanedione (BMPP), 1- (p- t- butylphenyl)- 3- (p- methoxyphenyl)- 1, 3- propanedione (BMDBM), 1- (4- fluorophenyl)- 3- (2- thienyl)- 1, 3- propanedione (FTP), 1, 3- diphenyl- 1, 3- propanedione, benzoylacetone, dibenzoylacetone, diisobutyloylmethane, dipivaloylmethane, 3- methylpentane- 2, 4- dione, 2, 2- dimethylpentane- 3, 5- dione, 2- methyl- 1, 3- butanedione, 1, 3- butanedione, 3- phenyl- 2, 4- pentanedione, 1, 1, 1- trifluoro- 2, 4- pentanedione, 1, 1, 1- trifluoro- 5, 5- dimethyl- 2, 4- hexanedione, 2, 2, 6, 6- tetramethyl- 3, 5- heptanedione, 3- methyl- 2, 4- pentanedione, 2- acetylcyclopentanone, 2- acetylcyclohexanone, 1- heptafloropropyl- 3- t- butyl- 1, 3- propanedione, 1, 3- diphenyl- 2- methyl- 1, 3- propanedione, and 1- ethoxy- 1, 3- butanedione.

Examples of the nitrogen- containing organic compounds, nitrogen- containing aromatic heterocyclic compounds, or phosphine oxides as the neutral ligands of the rare earth complex include 1, 10- phenanthroline, 2, 2'- bipyridyl, 2, 2'- 6, 2"- terpyridyl, 4, 7- diphenyl- 1, 10- phenanthroline, 2- (2- pyridyl) benzimidazole, triphenylphosphine oxide, tri- n- butylphosphine oxide, tri- n- octylphosphine oxide, and tri- n- butyl phosphate.

Among these, from the viewpoint of wavelength conversion efficiency, Eu (TTA)$_3$phen ((1, 10- phenanthroline) tris [4, 4, 4- trifluoro- 1- (2- thienyl)- 1, 3- butanedionato] europium (III) ), Eu (BMPP)$_3$phen ((1, 10- phenanthroline) tris [1- (p- t- butylphenyl)- 3- (N- methyl- 3- pyrrole)- 1, 3- propanedionato] europium (III) ), Eu (BMDBM)$_3$phen ((1- 10- phenanthroline) tris [1- (p- t- butylphenyl)- 3- (p- methoxyphenyl)- 1, 3- propanedionato] europium (III) ) ), Eu (FTP)$_3$phen ((1, 10- phenanthroline) tris [1- (4- fluorophenyl)- 3- (2- thienyl)- 1, 3- propanedionato] europium (III) ) ), and the like are preferably used as the rare earth complex having the ligand mentioned above.

A method of manufacturing Eu (TTA)$_3$phen or the like may refer to, for example, a method disclosed in Masaya Mitsuishi, Shinji Kikuchi, Tokuji Miyashita, Yutaka Amano, J.Mater.Chem. 2003, 13, 285- 2879.

According to the present invention, a photovoltaic cell module having a high power generation efficiency can be configured by using, in particular, a europium complex as the fluorescent substance. The europium complex converts light in the ultraviolet region into light in the red wavelength region at a high wavelength conversion efficiency, and the converted light contributes to power generation in a photovoltaic cell element.

A content of the fluorescent substance in the spherical phosphor according to the present invention is not particularly limited and may be appropriately selected according to the purpose or the kind of the fluorescent substance. However, from the viewpoint of power generation efficiency, the content is preferably from 0.001% by mass to 1% by mass and more preferably from 0.01% by mass to 0.5% by mass, with respect to the total mass of the spherical phosphor.

(Transparent Material)

The fluorescent substance according to the present invention is contained in a transparent material. Being transparent in the present invention represents that the transmittance of light having a wavelength range of 400 nm to 800 nm at an optical path length of 1 cm is 90% or higher.

The transparent material is not particularly limited as long as it is transparent, and examples thereof include resins such as acrylic resin, methacrylic resin, urethane resin, epoxy resin, polyester, polyethylene, and polyvinyl chloride. Among these, acrylic resin and methacrylic resin are preferable from the viewpoint of suppressing light scattering. A monomer compound forming the resin is not particularly limited, but a vinyl compound is preferable from the viewpoint of suppressing light scattering.

Examples of a method of making the fluorescent substance contained in the transparent material and forming a spherical shape include a method in which the fluorescent substance is dissolved or dispersed in a monomer compound to prepare a composition, followed by polymerization (emulsion polymerization or suspension polymerization) of the composition. Specifically, for example, a mixture containing the fluorescent substance and a vinyl compound is prepared, and the mixture is emulsified or dispersed in a medium (for example, an aqueous medium) to obtain an emulsion or a suspension. Then, the vinyl compound contained in the emulsion or suspension is polymerized (emulsion polymerization or suspension polymerization) using, for example, a radical polymerization initiator, thereby obtaining a spherical phosphor as spherical resin particles containing the fluorescent substance.

In the present invention, from the viewpoint of power generation efficiency, it is preferable that a mixture containing the fluorescent substance and the vinyl compound is prepared; the mixture is dispersed in a medium (for example, an aqueous medium) to obtain a suspension; and the vinyl compound contained in the suspension is polymerized (suspension polymerization) using, for example, a radical polymerization initiator, thereby obtaining a spherical phosphor as spherical resin particles containing the fluorescent substance.

(Vinyl Compound)

The vinyl compound according to the present invention is not particularly limited as long as it is a compound having at least one ethylenic unsaturated bond.

For the polymerization reaction, a vinyl resin, in particular, an acrylic monomer, a methacrylic monomer, an acrylic oligomer, a methacrylic oligomer, or the like, which is capable of forming an acrylic resin or methacrylic resin, may be used without limitation. In the present invention, for example, it is preferable that an acrylic monomer and a methacrylic monomer be used.

Examples of the acrylic monomer and the methacrylic monomer include acrylic acid, methacrylic acid, and alkyl esters thereof. The acrylic monomer or methacrylic monomer may be used in combination with another vinyl compound which is polymerizable therewith. One kind thereof may be used alone, or two or more kinds thereof may be used in combination.

Examples of acrylic acid alkyl esters and methacrylic acid alkyl esters include unsubstituted alkyl esters of acrylic acid and unsubstituted alkyl esters of methacrylic acid, such as methyl acrylate, methyl methacrylate, ethyl acrylate, ethyl methacrylate, butyl acrylate, butyl methacrylate, 2- ethylhexyl acrylate, or 2- ethylhexyl methacrylate; dicyclopentenyl (meth) acrylate; tetrahydrofurfuryl (meth) acrylate; benzyl (meth) acrylate; compounds obtained by a reaction of a polyol with an α, β- unsaturated carboxylic acid (for example, polyethylene glycol di (meth) acrylate (having 2 to 14 ethylene groups), trimethylolpropane di (meth) acrylate, trimethylolpropane tri (meth) acrylate, trimethylolpropane ethoxytri (meth) acrylate, trimethylolpropane propoxytri (meth) acrylate, tetramethylolmethane tri (meth) acrylate, tetramethylolmethane tetra (meth) acrylate, polypropylene glycol di (meth) acrylate (having 2 to 14 propylene groups), dipentaerythritol penta (meth) acrylate, dipentaerythritol hexa (meth) acrylate, bisphenol A polyoxyethylene di (meth) acrylate, bisphenol A dioxyethylene di (meth) acrylate, bisphenol A trioxyethylene di (meth) acrylate, or bisphenol A decaoxyethylene di (meth) acrylate) ; compounds obtained by the addition of an α, β- unsaturated carboxylic acid to a glycidyl group- containing compound (for example, trimethylolpropane triglycidyl ether triacrylate or bisphenol A diglycidyl ether diacrylate) ; esterification products of a polyvalent carboxylic acid (such as phthalic anhydride) and a substance having a hydroxyl group and an ethylenically unsaturated group (such as β- hydroxyethyl (meth) acrylate) ; urethane (meth) acrylates (such as a reaction product of tolylene diisocyanate and 2- hydroxyethyl (meth) acrylic acid ester, or a reaction product between trimethylhexamethylene diisocyanate, cyclohexanedimethanol, and 2- hydroxyethyl (meth) acrylic acid ester) ; and substituted alkyl esters of acrylic acid or substituted alkyl esters of methacrylic acid in which the alkyl group of the above- mentioned compounds is substituted with a hydroxyl group, an epoxy group, or a halogen group.

In addition, examples of other vinyl compounds which are polymerizable with acrylic acid, methacrylic acid, acrylic acid alkyl esters, or methacrylic acid alkyl esters include acryl amide, acrylonitrile, diacetone acrylamide, styrene, and vinyl toluene. These vinyl monomers may be used alone, or in combination of two or more kinds thereof.

The vinyl compound according to the present invention may be appropriately selected such that the refractive index of formed resin particles has a desired value. As the vinyl compound, it is preferable that at least one kind selected from acrylic acid alkyl esters or methacrylic acid alkyl esters be used, it is more preferable that at least one kind selected from unsubstituted alkyl esters of acrylic acid or unsubstituted alkyl esters of methacrylic acid be used; and it is still more preferable to use at least one kind selected from unsubstituted alkyl esters of acrylic acid or unsubstituted alkyl esters of methacrylic acid and a compound obtained by a reaction between a polyhydric alcohol and an α,β-unsaturated carboxylic acid.

When at least one kind (hereinafter, also referred to as "vinyl compound A") selected from unsubstituted alkyl esters of acrylic acid or unsubstituted alkyl esters of methacrylic acid and a compound (hereinafter, also referred to as "vinyl compound B") obtained by a reaction of a polyhydric alcohol with an α,β-unsaturated carboxylic acid are used as the vinyl compounds in the present invention, a usage ratio of the vinyl compound B to the vinyl compound A (vinyl compound B/vinyl compound A) is preferably from 0.001 to 0.1, and more preferably from 0.005 to 0.05, for example, from the viewpoint of power generation efficiency.

(Radical Polymerization Initiator)

In the present invention, it is preferable that a radical polymerization initiator be used in order to polymerize the vinyl compound. The radical polymerization initiator is not particularly limited, and a radical polymerization initiator which is normally used may be used. For example, a peroxide or the like is preferably used. Specifically, an organic peroxide or azo radical initiator which is capable of producing free radicals by heat is preferably used.

Examples of the organic peroxide which may be used include isobutyl peroxide, α, α'- bis (neodecanoylperoxy) diisopropylbenzene, cumyl peroxyneodecanoate, di- n- propyl peroxydicarbonate, bis- s- butyl peroxydicarbonate, 1, 1, 3, 3- tetramethylbutyl neodecanoate, bis (4- t- butylcyclohexyl) peroxydicarbonate, 1- cyclohexyl- 1- methylethyl peroxyneodecanoate, bis- 2- ethoxyethyl peroxydicarbonate, bis (ethylhexyl) peroxydicarbonate, t- hexyl neodecanoate, bismethoxybutyl peroxydicarbonate, bis (3- methyl- 3- methoxybutyl) peroxydicarbonate, t- butyl peroxyneodecanoate, t- hexyl peroxypivalate, 3.5, 5- trimethylhexanoyl peroxide, octanoyl peroxide, lauroyl peroxide, stearoyl peroxide, 1, 1, 3, 3- tetramethylbutyl peroxy- 2- ethylhexanoate, succinic peroxide, 2, 5- dimethyl- 2, 5- bis (2- ethylhexanoyl) hexane, 1- cyclohexyl- 1- methylethyl peroxy- 2- ethylhexanoate, t- hexyl peroxy- 2- ethylhexanoate, 4- methylbenzoyl peroxide, t- butyl peroxy- 2- ethylhexanoate, m- toluoylbenzoyl peroxide, benzoyl peroxide, t- butyl peroxy isobutyrate, 1, 1- bis (t- butylperoxy)- 2- methylcyclohexane, 1, 1- bis (t- hexylperoxy)- 3, 3, 5- trimethylcyclohexane, 1, 1- bis (t- hexylperoxy) cyclohexane, 1, 1- bis (t- butylperoxy)- 3, 3, 5- trimethylcyclohexane, 1, 1- bis (t- butylperoxy) cyclohexanone, 2, 2- bis (4, 4- dibutylperoxycyclohexyl) propane, 1, 1- bis (t- butylperoxy) cyclododecane, t- hexyl peroxyisopropyl monocarbonate, t- butylperoxymaleic acid, t- butyl peroxy- 3, 5, 5- trimethylhexanoate, t- butyl peroxylaurate, 2, 5- dimethyl- 2, 5- bis (m- toluoylperoxy) hexane, t- butyl peroxyisopropyl monocarbonate, t- butyl peroxy- 2- ethylhexyl monocarbonate, t- hexyl peroxybenzoate, 2, 5- dimethyl- 2, 5- bis (benzoylperoxy) hexane, t- butyl peroxyacetate, 2, 2- bis (t- butylperoxy) butane, t- butyl peroxybenzoate, n- butyl 4, 4- bis (t- butylperoxy) valerate, di- t- butyl peroxyisophthalate, $\alpha, \alpha'$- bis (t- butylperoxy) diisopropylbenzene, dicumyl peroxide, 2, 5- dimethyl- 2, 5- di (t- butylperoxy) hexane, t- butyl cumyl peroxide, di- t- butylperoxy, p- menthane hydroperoxide, 2, 5- dimethyl- 2, 5- bis (t- butylperoxy) hexyne, diisopropylbenzene hydroperoxide, t- butyl trimethylsilyl peroxide, 1, 1, 3, 3- tetramethylbutyl hydroperoxide, cumene hydroperoxide, t- hexyl hydroperoxide, t- butyl hydroperoxide, and 2, 3- dimethyl- 2, 3- diphenylbutane.

Examples of the azo radical initiator include azobisisobutyronitrile (AIBN, trade name: V- 60 manufactured by Wako Pure Chemical Industries, Ltd.), 2, 2'- azobis (2- methylisobutyronitrile) (trade name: V- 59 manufactured by Wako Pure Chemical Industries, Ltd.), 2, 2'- azobis (2, 4- dimethylvaleronitrile) (trade name: V- 65 manufactured by Wako Pure Chemical Industries, Ltd.), dimethyl- 2, 2'- azobis (isobutyrate) (trade name: V- 601 manufactured by Wako Pure Chemical Industries, Ltd.), and 2, 2'- azobis (4- methoxy- 2, 4- dimethylvaleronitrile) (trade name: V- 70 manufactured by Wako Pure Chemical Industries, Ltd.) .

The amount of the radical polymerization initiator to be used may be appropriately selected according to the kind of the vinyl compound, the refractive index of the resin particles to be formed, or the like, and the radical polymerization initiator is used in amount which is normally used. Specifically, for example, the amount thereof is preferably from 0.01 % by mass to 2% by mass and more preferably from 0.1 % by mass to 1% by mass, with respect to the vinyl compound.

In the present invention, the refractive index of the transparent material is not particularly limited. However, from the viewpoint of suppressing light scattering, the refractive index is preferably less than the refractive index of the fluorescent substance, and it is more preferable that the refractive index be less than the refractive index of the fluorescent substance and that the ratio thereof to the refractive index of a sealing resin mentioned below be approximately 1. In general, the refractive index of the fluorescent substance is larger than 1.5 and the refractive index of the sealing resin is approximately 1.4 to 1.5. Therefore, the refractive index of the transparent material is preferably from 1.4 to 1.5.

In addition, it is preferable that the spherical phosphor have a refractive index which is larger than that of the sealing resin as a dispersion medium in the excitation wavelength of the fluorescent substance and is smaller than that of the sealing resin in the emission wavelength. With such a configuration, the light utilization efficiency in the excitation wavelength region is further improved.

<Method of Producing Spherical Phosphor>

Examples of a method of producing a spherical phosphor by making the fluorescent substance and, optionally, a radical scavenger or the like contained in a transparent material and forming a spherical shape include a method in which the fluorescent substance and the radical scavenger are dissolved or dispersed in the monomer compound to prepare a composition, followed by polymerization (emulsion polymerization or suspension polymerization) of the composition. Specifically, for example, a mixture containing the fluorescent substance, the radical scavenger, and the vinyl compound is prepared, and the mixture is emulsified or dispersed in a medium (for example, an aqueous medium) to obtain an emulsion or a suspension. Then, the vinyl compound contained in the emulsion or suspension is polymerized (emulsion polymerization or suspension polymerization) using, for example, a radical polymerization initiator to obtain a spherical phosphor as spherical resin particles containing the fluorescent substance.

In the present invention, from the viewpoint of power generation efficiency, it is preferable that a mixture containing the fluorescent substance and the vinyl compound is prepared; the mixture is dispersed in a medium (for example, an aqueous medium) to obtain a suspension; and the vinyl compound contained in the suspension is polymerized (suspension polymerization) using, for example, a radical polymerization initiator to obtain a spherical phosphor as spherical resin particles containing the fluorescent substance.

An average particle size of the spherical phosphor according to the present invention is preferably from 1 $\mu$m to 600 $\mu$m, more preferably from 5 $\mu$m to 300 $\mu$m, and still more preferably from 10 $\mu$m to 250 $\mu$m. The average particle size of the spherical phosphor is measured by a laser diffraction method and corresponds to a particle size in which the cumulative weight is 50% when a weight cumulative particle size distribution curve is drawn from a small particle size side. In order to measure the particle size distribution by a laser diffraction method, a laser diffraction scattering particle size analyzer (for example, LS 13320, manufactured by Beckman Coulter, Inc.) may be used.

<Wavelength Conversion-Type Photovoltaic Cell Sealing Material>

A wavelength conversion-type photovoltaic cell sealing material according to the present invention is used as a light-permeable layer of a photovoltaic cell module and includes at least one light-permeable resin composition layer having wavelength conversion capability. The resin composition layer includes at least one kind of the spherical phosphor and at least one kind of a sealing resin (preferably, a transparent sealing resin) in which the spherical phosphor is dispersed in the sealing resin.

When the wavelength conversion-type photovoltaic cell sealing material includes the resin composition layer including the spherical phosphor and is used as a light-permeable layer in a photovoltaic cell module, the light utilization efficiency thereof can be improved and the power generation efficiency can be stably improved.

Light scattering correlates with the refractive index of the spherical phosphor and the refractive index of the sealing resin. Specifically, regarding light scattering, when the ratio of the refractive index of the spherical phosphor to the refractive index of the transparent sealing resin is approximately "1", the influence of the particle size of the spherical phosphor is reduced and light scattering is also suppressed. In particular, when the present invention is applied to a wavelength conversion-type light-permeable layer of a photovoltaic cell module, it is preferable that the refractive index ratio be approximately "1" in a wavelength region having a sensitivity of the photovoltaic cell module, that is, 400 nm to 1200 nm. On the other hand, in order to efficiently cause the total reflection of light in the excitation wavelength region to occur in the spherical phosphor, it is preferable that the refractive index of the spherical phosphor in the excitation wavelength region be larger than that of the sealing resin which is a medium.

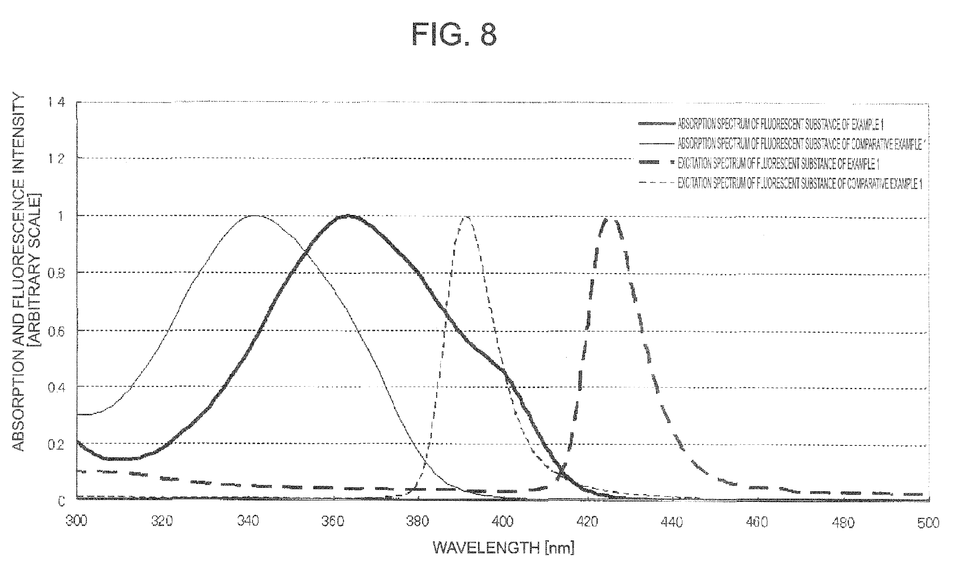

In order to satisfy the requirements, for example, Eu (FTP)$_3$phen ((1, 10- phenanthroline) tris [1- (4- fluorophenyl)- 3- (2- thienyl)- 1, 3- propanedionato] europium (III) ), which is disclosed in Japanese Patent Application No. 2010- 260326, is used as the fluorescent substance; a spherical body obtained by suspension polymerization of 95% by mass of methyl methacrylate and 5% by mass of ethylene glycol dimethacrylate is used as the transparent material (spherical base material) ; and ethylene- vinyl acetate copolymer (EVA) is used as the sealing resin. As a result, a particularly satisfactory refractive index correlation can be established from the viewpoints of the excitation wavelength and emission wavelength and furthermore from the viewpoint of the sensitivity of a photovoltaic cell. However, as can be seen from FIG. 2, in the fluorescent substance and the spherical phosphor using the same, generally, the shapes of the excitation spectra do not match with each other. This phenomenon occurs because a difference between environmental influences (interaction) in the molecular level is reflected as a so- called solvent effect. However, the phenomenon is caused by the transition between levels of the excitation state and correlates with the absorption wavelength present in absorption spectrum of FIG. 8. In general, regarding fluorescence of the fluorescent substance in the solution state, fluorescence emission in the lowest excitation level of absorption increases.

However, in the present invention, it is preferable that the fluorescent substance, the transparent material, and the sealing material be appropriately selected such that the fluorescence excitation wavelengths of the fluorescent substance and the spherical phosphor using the same satisfy the above- mentioned conditions; and the correlation between the refractive indices of the fluorescent substance, the transparent material, and the sealing resin satisfies the above- mentioned conditions, and the present invention is not limited to the above- mentioned combination.

The preferable amount of the spherical phosphor to be formulated in the wavelength converting resin composition layer, which is included in the wavelength conversion-type photovoltaic cell sealing material, is preferably from 0.0001% by mass to 10% by mass in mass concentration with respect to the total amount of nonvolatile components. When the amount is equal to or larger than 0.0001% by mass, the luminous efficiency is improved. When the amount is equal to or smaller than 10% by mass, the scattering of incident light is effectively suppressed and thus the power generation effect is further improved.

(Sealing Resin)

The wavelength converting resin composition layer according to the present invention includes a sealing resin (transparent sealing resin). As the transparent sealing resin, a photocurable resin, a thermosetting resin, a thermoplastic resin, or the like is preferably used. Conventionally, thermosetting ethylene-vinyl acetate (EVA) copolymers are widely used as resins for a transparent sealing material of a photovoltaic cell. However, the present invention is not limited thereto.

When a photocurable resin is used as a dispersion medium resin (transparent sealing resin) of a resin composition for the wavelength conversion-type photovoltaic cell sealing material, a resin configuration of the photocurable resin and a photocuring method are not particularly limited. For example, in a photocuring method using a radical photoinitiator, the resin composition for the wavelength conversion-type photovoltaic cell sealing material is formed of a dispersion medium resin containing (A) a photocurable resin, (B) a crosslinking monomer, and (C) a photoinitiator which produces free radicals by light, in addition to the spherical resin particles.

Here, as (A) the photocurable resin, copolymers obtained by copolymerization of acrylic acid, methacrylic acid, or an alkyl ester thereof and another vinyl monomer, which is copolymerizable therewith, as constituent monomers are used. These copolymers may be used alone or in combination of two or more kinds thereof. Examples of acrylic acid alkyl esters and methacrylic acid alkyl esters include unsubstituted alkyl esters of acrylic acid and unsubstituted alkyl esters of methacrylic acid, such as methyl acrylate, methyl methacrylate, ethyl acrylate, ethyl methacrylate, butyl acrylate, butyl methacrylate, 2- ethylhexyl acrylate, or 2- ethylhexyl methacrylate; and substituted alkyl esters of acrylic acid or substituted alkyl esters of methacrylic acid in which the alkyl group of the above- described compounds is substituted with a hydroxyl group, an epoxy group, or a halogen group.

Examples of another vinyl monomer which is polymerizable with acrylic acid, methacrylic acid, an acrylic acid alkyl ester, or a methacrylic acid alkyl ester include acryl amide, acrylonitrile, diacetone acrylamide, styrene, and vinyl toluene. These vinyl monomers may be used alone or in combination of two or more kinds thereof. The weight average molecular weight of the photocurable resin (dispersion medium resin) as the component (A) is preferably from 10,000 to 300,000 from the viewpoints of coated film properties and coated film strength.

Examples of the (B) crosslinking monomer include compounds obtained by a reaction of a polyhydric alcohol with an $\alpha$, $\beta$- unsaturated carboxylic acid (such as polyethylene glycol di (meth) acrylate (having 2 to 14 ethylene groups), ethylene glycol dimethacrylate, trimethylolpropane di (meth) acrylate, trimethylolpropane tri (meth) acrylate, trimethylolpropane ethoxytri (meth) acrylate, trimethylolpropane propoxytri (meth) acrylate, tetramethylolmethane tri (meth) acrylate, tetramethylolmethane tetra (meth) acrylate, polypropylene glycol di (meth) acrylate (having 2 to 14 propylene groups), dipentaerythritol penta (meth) acrylate, dipentaerythritol hexa (meth) acrylate, bisphenol A polyoxyethylene di (meth) acrylate, bisphenol A dioxyethylene di (meth) acrylate, bisphenol A trioxyethylene di (meth) acrylate, or bisphenol A decaoxyethylene di (meth) acrylate) ; compounds obtained by the addition of an $\alpha$, $\beta$- unsaturated carboxylic acid to a glycidyl group- containing compound (such as trimethylolpropane triglycidyl ether triacrylate or bisphenol A diglycidyl ether diacrylate) ; esterification products of a polyvalent carboxylic acid (such as phthalic anhydride) and a substance having a hydroxyl group and an ethylenically unsaturated group (such as $\beta$- hydroxyethyl (meth) acrylate) ; and urethane (meth) acrylate (such as a reaction product of tolylene diisocyanate and 2- hydroxyethyl (meth) acrylic acid ester, or a reaction product of trimethylhexamethylene diisocyanate, cyclohexanedimethanol, and 2- hydroxyethyl (meth) acrylic acid ester) .

From the viewpoints of easy control of crosslinking density and reactivity, particularly preferable examples of the (B) crosslinking monomer include trimethylolpropane tri (meth) acrylate, dipentaerythritol tetra (meth) acrylate, dipentaerythritol hexa (meth) acrylate, and bisphenol A polyoxyethylene dimethacrylate. These compounds may be used alone or in combination of two or more kinds thereof.

As described below, in order to increase, particularly, the refractive index of the wavelength conversion-type photovoltaic cell sealing material or a lower layer thereof (on the side in contact with a photovoltaic cell module), it is effective that (A) the photocurable resin and/or (B) the crosslinking monomer contain/contains bromine or sulfur atoms. Examples of a bromine-containing monomer include NEW FRONTIER BR-31, NEW FRONTIER BR-30, and NEW FRONTIER BR-42M, which are manufactured by Daiichi Kogyo Seiyaku Industry Co., Ltd. Examples of a sulfur-containing monomer composition include IU-L2000, IU-L3000, and IU-MS1010, which are manufactured by Mitsubishi Gas Chemical Company, Inc. However, the bromine or sulfur atom-containing monomer (a polymer including the monomer) used in the present invention is not limited to these examples.

As (C) the photoinitiator, a photoinitiator which produces free radicals by ultraviolet rays or visible light rays is preferable, and examples thereof include benzoin ethers such as benzoin methyl ether, benzoin ethyl ether, benzoin propyl ether, benzoin isobutyl ether, or benzoin phenyl ether; benzophenones such as benzophenone, N, N'- tetramethyl- 4, 4'- diaminobenzophenone (Michler's ketone), or N, N'- tetraethyl- 4, 4'- diaminobenzophenone; benzyl ketals such as benzyl dimethyl ketal (IRGACURE 651 manufactured by BASF Japan Co., Ltd.) or benzyl diethyl ketal; acetophenones such as 2, 2- dimethoxy- 2- phenylacetophenone, p- tert- butyldichloroacetophenone, or p- dimethylaminoacetophenone; xanthones such as 2, 4- dimethylthioxanthone or 2, 4- diisopropylthioxanthone; and hydroxycyclohexylphenylketone (IRGACURE 184 manufactured by BASF Japan Co., Ltd.), 1- (4- isopropylphenyl)- 2- hydroxy- 2- methylpropan- 1- one (DAROCUR 1116 manufactured by BASF Japan Co., Ltd.) and 2- hydroxy- 2- methyl- 1- phenylpropan- 1- one (DAROCUR 1173 manufactured by BASF Japan Co., Ltd.) . These compounds may be used alone or in combination of two or more kinds thereof.

Examples of a photoinitiator which can be used as (C) the photoinitiator include a combination of a 2, 4, 5- triarylimidazole dimer with 2- mercapto- benzoxazole, Leuco Crystal Violet, tris (4- diethylamino- 2- methylphenyl) methane, or the like. In addition, an additive which is not a photoinitiator but, when being used in combination with the above- mentioned substances, acts as a sensitizer for exhibiting more satisfactory photoinitiation capability as a whole may be used, and, for example, a tertiary amine such as triethanolamine with respect to benzophenone may be used.

In order to obtain a thermosetting sealing resin, it is only necessary that a thermal initiator be used instead of (C) the photoinitiator.

As (C) the thermal initiator, an organic peroxide which produces free radicals by heat is preferable, and examples thereof include isobutyl peroxide, $\alpha$, $\alpha$'- bis (neodecanoyl peroxy) diisopropylbenzene, cumyl peroxyneodecanoate, di- n- propylperoxydicarbonate, di- s- butylperoxydicarbonate, 1, 1, 3, 3- tetramethylbutyl neodecanoate, bis (4- t- butylcyclohexyl) peroxydicarbonate, 1- cyclohexyl- 1- methylethylperoxyneodecanoate, bis- 2- ethoxyethylperoxydicarbonate, bis (ethylhexylperoxy) dicarbonate, t- hexyl neodecanoate, bismethoxybutylperoxydicarbonate, bis (3- methyl- 3- methoxybutylperoxy) dicarbonate, t- butylperoxyneodecanoate, t- hexylperoxypivalate, 3, 5, 5- trimethylhexanoylperoxide, octanoylperoxide, lauroylperoxide, stearoylperoxide, 1, 1, 3, 3- tetramethylbutylperoxy- 2- ethylhexanoate, succinic peroxide, 2, 5- dimethyl- 2, 5- bis (2- ethylhexanoyl) hexane, 1- cyclohexyl- 1- methylethylperoxy- 2- ethylhexanoate, t- hexylperoxy- 2- ethylhexanoate, 4- methylbenzoylperoxide, t- butylperoxy- 2- ethylhexanoate, m- toluoyl benzoyl peroxide, benzoyl peroxide, t- butylperoxyisobutylate, 1, 1- bis (t- butylperoxy) 2- methylcyclohexane, 1, 1- bis (t- hexylperoxy)- 3, 3, 5- trimethylcyclohexane, 1, 1- bis (t- hexylperoxy) cyclohexane, 1, 1- bis (t- butylperoxy)- 3, 3, 5- trimethylcyclohexane, 1, 1- bis (t- butylperoxy) cyclohexanone, 2, 2- bis (4, 4- dibutylperoxycyclohexyl) propane, 1, 1- bis (t- butylperoxy) cyclododecane, t- hexyl peroxyisopropyl monocarbonate, t- butylperoxymaleic acid, t- butyl peroxy- 3, 5, 5- trimethylhexanoate, t- butyl peroxylaurate, 2, 5- dimethyl- 2, 5- bis (m- toluoylperoxy) hexane, t- butyl peroxyisopropyl monocarbonate, t- butyl peroxy- 2- ethylhexyl monocarbonate, t- hexyl peroxybenzoate, 2, 5- dimethyl- 2, 5- bis (benzoylperoxy) hexane, t- butyl peroxyacetate, 2, 2- bis (t- butylperoxy) butane, t- butyl peroxybenzoate, n- butyl 4, 4- bis (t- butylperoxy) valerate, di- t- butyl peroxyisophthalate, α, α'- bis (t- butylperoxy) diisopropylbenzene, dicumyl peroxide, 2, 5- dimethyl- 2, 5- di (t- butylperoxy) hexane, t- butyl cumyl peroxide, p- menthane hydroperoxide, 2, 5- dimethyl- 2, 5- bis (t- butylperoxy) hexyne, diisopropylbenzene hydroperoxide, t- butyltrimethylsilyl peroxide, 1, 1, 3, 3- tetramethylbutyl hydroperoxide, cumene hydroperoxide, t- hexyl hydroperoxide, t- butyl hydroperoxide, and 2, 3- dimethyl- 2, 3- diphenylbutane.

They are examples of acrylic photocurable resins and acrylic thermosetting resins. However, epoxy photocurable resins and epoxy thermosetting resins which are normally used may also be used as the dispersion medium resin of the wavelength conversion-type photovoltaic cell sealing material according to the present invention. However, since the curing of epoxy is ionic, the spherical resin particles (coated phosphor) or the rare earth metal complex which is the fluorescent substance may be affected, which causes deterioration or the like. Accordingly, acrylic resins are more preferable.

When a thermoplastic resin which flows in response to heat or pressure is used as the dispersion medium resin of the wavelength conversion- type photovoltaic cell sealing material, examples of the dispersion medium resin which is usable include (di) enes such as natural rubber, polyethylene, polypropylene, polyvinyl acetate, polyisoprene, poly- 1, 2- butadiene, polyisobutene, polybutene, poly- 2- heptyl- 1, 3- butadiene, poly- 2- t- butyl- 1, 3- butadiene, or poly- 1, 3- butadiene; polyethers such as polyoxyethylene, polyoxypropyrene, polyvinyl ethyl ether, polyvinyl hexyl ether, or polyvinyl butyl ether; polyesters such as polyvinyl acetate or polyvinyl propionate; polyurethane; ethyl cellulose; polyvinyl chloride; polyacrylonitrile; polymethacrylonitrile; polysulfone; phenoxy resin; and poly (meth) acrylic acid esters such as polyethyl acrylate, polybutyl acrylate, poly- 2- ethylhexyl acrylate, poly- t- buyl acrylate, poly- 3- ethoxypropyl acrylate, polyoxycarbonyl tetramethacrylate, polymethyl acrylate, polyisopropyl methacrylate, polydodecyl methacrylate, polytetradecyl methacrylate, poly- n- propyl methacrylate, poly- 3, 3, 5- trimethylcyclohexyl methacrylate, polyethyl methacrylate, poly- 2- nitro- 2- methylpropyl methacrylate, poly- 1, 1- diethylpropyl methacrylate, or polymethyl methacrylate.

Optionally, these thermoplastic resins may be copolymerized in a combination of two or more kinds or may be used as a mixture in which two or more kinds thereof are blended.

Furthermore, examples of a resin which is copolymerizable with the above- described resins include epoxy acrylate, urethane acrylate, polyether acrylate, and polyester acrylate. In particular, from the viewpoint of adhesion, urethane acrylate, epoxy acrylate, and polyether acrylate are desirable.

Examples of epoxy acrylate include (meth) acrylic acid adducts such as 1,6-hexanediol diglycidyl ether, neopentyl glycol diglycidyl ether, allyl alcohol diglycidyl ether, resorcinol diglycidyl ether, adipic acid diglycidyl ester, phthalic acid diglycidyl ester, polyethylene glycol diglycidyl ether, trimethylolpropane triglycidyl ether, glycerin triglycidyl ether, pentaerythritol tetraglycidyl ether, or sorbitol tetraglycidyl ether.

Polymers having a hydroxyl group in the molecules such as epoxy acrylate are effective for improving adhesion property. These copolymer resins may be used, optionally, in combination of two or more kinds thereof. The softening temperature of these resins is preferably less than or equal to 200°C and more preferably less than or equal to 150°C, from the viewpoint of handleability. Given that the usage environment temperature of a photovoltaic cell unit is generally lower than or equal to 80°C and from the viewpoint of the workability, the softening temperature of the resins is particularly preferably from 80°C to 120°C.

When a thermoplastic resin is used as the dispersion medium resin (sealing resin), other configurations of the resin composition are not particularly limited as long as the above-mentioned coated phosphor is contained therein. However, components which are normally used such as a plasticizer, a flame retardant, or a stabilizer may be added.

The dispersion medium resin of the wavelength conversion-type photovoltaic cell sealing material according to the present invention is not particularly limited to the photocurable, thermosetting, and thermoplastic resins mentioned above. However, particularly preferable examples of the resin include a composition obtained by mixing a thermal radical initiator with an ethylene-vinyl acetate copolymer which is widely used as a photovoltaic cell sealing material in the related art.

The wavelength conversion-type photovoltaic cell sealing material according to the present invention may be configured by only a wavelength converting resin composition layer containing the spherical phosphor and the sealing resin; but, preferably, further include a light permeable layer other than the resin composition layer. Examples of the light-permeable layer other than the resin composition layer include a light-permeable layer obtained by removing the spherical phosphor from the wavelength converting resin composition layer.

When the wavelength conversion-type photovoltaic cell sealing material according to the present invention is configured to have plural light-permeable layers, it is preferable that the refractive index is equal to or higher than that of a layer which is closer to a light incident side.

Specifically, when a number, m, of light-permeable layers are represented by layer 1, layer 2, ..., layer (m-1), and layer m in this order from the light incident side; and the refractive indices of the light permeable layers are represented by $n_1$, $n_2$, ..., $n_{(m-1)}$, and $n_m$, respectively, it is preferable that the following expression be satisfied: $n_1 \leq n_2 \leq ... \leq n_{(m-1)} \leq n_m$.

The refractive index of the wavelength conversion-type photovoltaic cell sealing material according to the present invention is not particularly limited, but is preferably from 1.5 to 2.1, and more preferably from 1.5 to 1.9. When the wavelength conversion-type photovoltaic cell sealing material according to the present invention is configured to include plural light-permeable layers, it is preferable that the overall refractive index of the wavelength conversion-type photovoltaic cell sealing material be within the above-described ranges.

It is preferable that the wavelength conversion-type photovoltaic cell sealing material according to the present invention be disposed on a light receiving surface of a photovoltaic cell element. By doing so, the wavelength conversion-type photovoltaic cell sealing material can follow the asperity pattern including a texture structure, a cell electrode, a tab wire, or the like on the light receiving surface of the photovoltaic cell element, without gaps therebetween.

<Method of Producing Wavelength Conversion-type Photovoltaic Cell Sealing Material>

The method of manufacturing a wavelength conversion-type photovoltaic cell sealing material according to the present invention includes: (1) a step of synthesizing a fluorescent substance; (2) a step of obtaining a spherical phosphor by suspension polymerization of a vinyl monomer composition in which the fluorescent substance is dissolved or dispersed; and (3) a sheet forming step of forming a resin composition, obtained by mixing or dispersing the spherical phosphor with or in a sealing resin (transparent sealing resin), into a sheet form.

The details of the step of obtaining the spherical phosphor are as described above. In the sheet forming step, methods such as extrusion molding or calendar molding, which are methods generally used for forming a resin composition into a sheet form, may be used without particular limitation.

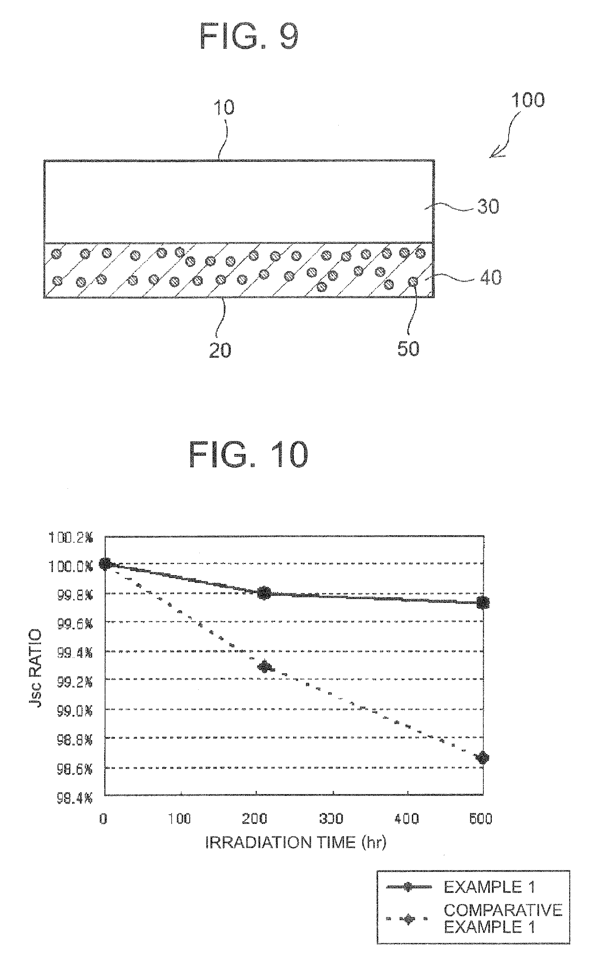

From the viewpoint of usability, it is preferable that the wavelength conversion-type photovoltaic cell sealing material according to the present invention be formed into a sheet form. As illustrated in FIG. 9, in particular, it is more preferable that a wavelength conversion-type photovoltaic cell sealing material 100 have a two-layer structure of a resin layer (referred to as "support layer 30") that is disposed at a glass side and does not include a spherical phosphor 50; and a resin layer (referred to as "light emitting layer 40") that is disposed at a cell side and includes the spherical phosphor 50. The wavelength conversion-type photovoltaic cell sealing material 100 may be used as a photovoltaic cell module by disposing a protective glass (cover glass, not illustrated) in contact with a glass-side surface 10 and disposing a photovoltaic cell element (not illustrated) in contact with a cell-side surface 20.

In the present invention, it is preferable that the manufacturing method include (1) a step of obtaining a spherical phosphor by suspension polymerization of a vinyl monomer composition in which a fluorescent substance (preferably, an europium complex) having an excitation band in a specific wavelength is dissolved or dispersed; and (2) a sheet forming step of forming a resin composition, obtained by dispersing the spherical phosphor in a sealing resin (transparent sealing resin), into a sheet form.

<Photovoltaic cell Module>

The present invention also encompasses a photovoltaic cell module including the wavelength conversion-type photovoltaic cell sealing material. The photovoltaic cell module according to the present invention includes a photovoltaic cell element; and the wavelength conversion-type photovoltaic cell sealing material that is disposed on a light receiving surface of the photovoltaic cell element. As a result, the power generation efficiency is improved.

The wavelength conversion-type photovoltaic cell sealing material according to the present invention is used, for example, as a light-permeable layer of a photovoltaic cell module including plural light-permeable layers and a photovoltaic cell element.

In the present invention, a photovoltaic cell module includes necessary components such as an antireflection film, a protective glass, a wavelength conversion-type photovoltaic cell sealing material, a photovoltaic cell element, a back film, a cell electrode, or a tab wire. Among these components, examples of light-permeable layers includes an antireflection film, a protective glass, the wavelength conversion-type photovoltaic cell sealing material according to the present invention, and a SiNx:H layer and a Si layers of a photovoltaic cell element.

In the present invention, the superimposition order of the light-permeable layers mentioned above is normally an antireflection layer which is optionally formed, a protective glass, the wavelength conversion-type photovoltaic cell sealing material according to the present invention, and a SiNx:H layer and a Si layer of the photovoltaic cell element in this order from the light receiving surface of the photovoltaic cell module.

That is, in the wavelength conversion-type photovoltaic cell sealing material according to the present invention, in order to efficiently guide all the external light rays, incident from all the directions, into a photovoltaic cell module without reflection loss, it is preferable that the refractive index of the wavelength conversion-type photovoltaic cell sealing material be higher than the refractive indices of the light-permeable layers which are disposed closer to the light incident side than the wavelength conversion-type photovoltaic cell sealing material, that is, of the antireflection film and the protective glass; and be lower than the refractive indices of the light-permeable layers which are disposed closer to the opposite side to the light incident side than the wavelength conversion-type photovoltaic cell sealing material, that is, of the SiNx:H (also referred to as "cell antireflection film") and the Si layers of the photovoltaic cell element.

Specifically, the refractive indices of the light-permeable layers which are disposed closer to the light incident side than the wavelength conversion- type photovoltaic cell sealing material, that is, the refractive index of the antireflection film is normally from 1.25 to 1.45 and the refractive index of the protective glass is normally from 1.45 to 1.55. The refractive indices of the light- permeable layers which are disposed closer to the opposite side to the light incident side than the wavelength conversion- type photovoltaic cell sealing material, that is, the refractive index of the SiNx: H layer (cell antireflection layer) of the photovoltaic cell element is normally from about 1.9 to 2.1 and the refractive index of the Si layer is normally from about 3.3 to 3.4. In this manner, the refractive index of the wavelength conversion- type photovoltaic cell sealing material according to the present invention is preferably from 1.5 to 2.1, and more preferably from 1.5 to 1.9.

A photovoltaic cell module having a high power generation efficiency can be realized by using an europium complex as the fluorescent substance having an excitation band in a specific wavelength which is used in the wavelength conversion-type photovoltaic cell sealing material according to the present invention. The europium complex converts light in the ultraviolet region into light in the red wavelength region, and the converted light contributes to power generation in a photovoltaic cell element.

<Method of Producing Photovoltaic Cell Module>

A photovoltaic cell module is produced by forming, on a photovoltaic cell element, a wavelength conversion-type photovoltaic cell sealing material using a sheet-form resin composition which is the wavelength conversion-type photovoltaic cell sealing material according to the present invention.

Specifically, a method of producing a photovoltaic cell module according to the present invention is substantially the same as a generally-used method of producing a crystalline silicon photovoltaic cell module, except that the wavelength conversion-type photovoltaic cell sealing material according to the present invention is used instead of a generally-used sealing material sheet. In particular, in the case of the two-layer structure including the support layer and the light emitting layer (wavelength conversion-type photovoltaic cell sealing material), it is should be noted that the support layer be arranged in contact with the glass side and the light emitting layer be arranged in contact with the photovoltaic cell element side.

Generally, in a case of a crystalline silicon photovoltaic cell module, first, a sheet- like sealing material (in many cases, a thermosetting material obtained by mixing an ethylene- vinyl acetate copolymer with a thermal radical initiator) is disposed on a cover glass which is a light receiving surface. In the present invention, as the sealing material used in this process, the wavelength conversion- type photovoltaic cell sealing material according to the present invention is used. Next, a photovoltaic cell module connected to a tab wire is disposed thereon, a sheet- like sealing material (provided that, in the present invention, the wavelength conversion- type photovoltaic cell sealing material should be used only on a light receiving surface; and a conventional sealing material may be used for this back surface) is disposed thereon, and a back sheet is disposed thereon. Then, a module is obtained using a vacuum pressure laminator for a photovoltaic cell module.

At this time, the temperature of a heating plate of the laminator is a temperature which is necessary for softening and melting a sealing material to cover a photovoltaic cell element and curing the sealing material, and is set to normally from 120°C to 180°C, and mostly from 140°C to 160°C such that physical changes and chemical changes are caused to occur.

The wavelength conversion-type photovoltaic cell sealing material according to the present invention refers to one in a state before being integrated into a photovoltaic cell module, and specifically refers to that in a semi-cured state when a curable resin is used. There is no large difference between refractive indices of the semi-cured wavelength conversion-type photovoltaic cell sealing material and wavelength conversion-type photovoltaic cell sealing material after curing (after being integrated a photovoltaic cell module).

The configuration of the wavelength conversion-type photovoltaic cell sealing material according to the present invention is not particularly limited, but is preferably sheet-like from the viewpoint of easy manufacturing of a photovoltaic cell module.

EXAMPLES

Hereinafter, the present invention will be described in further details by way of examples. However, the present invention is not limited to these examples. "Part (s) " and "%" represents "part (s) by mass" and "% by mass", respectively, unless specified otherwise.

(Example 1)

<Synthesis of FTP [1-(4-fluorophenyl)-3-(2-thienyl)-1,3-propanedione]>

First, 0.96 g (0.04 mol) of sodium hydroxide was weighed, and 22.5 ml of dehydrated tetrahydrofuran was added thereto in a nitrogen atmosphere. A solution obtained by dissolving 2.52 g (0.02 mol) of 2- acetylthiophene and 3.70 g (0.024 mol) of 4- fluoromethyl benzoate in 12.5 ml of dehydrated tetrahydrofuran was added dropwise thereto for 1 hour under intensive stirring. Then, reflux was caused under nitrogen steam for 8 hours. The resultant was cooled to room temperature (25°C), 10.0 g of pure water was added thereto, and 5.0 ml of 3N hydrochloric acid was added thereto. The organic layer was separated and concentrated under reduced pressure. The concentrate was recrystallized, thereby obtaining 2.83 g (yield: 57%) of FTP.

<Synthesis of Eu(FTP)$_3$Phen>

Then, 556.1 mg (2.24 mmol) of the synthesized FTP and 151.4 mg (0.84 mmol) of 1, 10- phenanthroline (Phen) were dispersed in 25.0 g of methanol. A solution obtained by dissolving 112.0 mg (2.80 mmol) of sodium hydroxide in 10.0 g of methanol was added to this dispersion, followed by stirring for 1 hour.
Next, a solution obtained by dissolving 256.5 mg (0.7 mmol) of europium (III) chloride hexahydrate in 5.0 g of methanol was added dropwise thereto. Stirring was performed at room temperature for 2 hours and the produced precipitate was separated by suction filtration, followed by washing with methanol. Then, drying was performed, thereby obtaining Eu (FTP)$_3$Phen as a fluorescent substance.
Regarding the obtained fluorescent substance, the excitation spectrum at a fluorescence wavelength of 621 nm was measured using a fluorescence spectrophotometer (F- 4500 manufactured by Hitachi High- Technologies Corporation) and using dimethylformamide as a solvent. The results are shown in FIGS. 2, 3, 4, and 8. It can be seen from FIGS. 2, 3, 4, and 8 that the maximum excitation wavelength of the obtained fluorescent substance is 425 nm.

<Preparation of Spherical Phosphor>

0.05 g of the obtained fluorescent substance Eu (FTP)$_3$Phen, 95 g of methyl methacrylate, 5 g of ethylene glycol dimethacrylate, and 0.5 g of thermal radical initiator 2, 2'- azobis (2, 4- dimethylvaleronitrile) were respectively weighed and put into a 200- ml screw pipe, followed by stirring and mixing using a ultrasonic washer and a mix rotor. Then, 500 g of ion exchange water and 59.1 g of a 1.69% polyvinyl alcohol solution as a surfactant were put into a separable flask equipped with a cooling pipe, followed by stirring. The resultant was added to the mixed solution of methyl methacrylate and ethylene glycol dimethacrylate, prepared in advance, followed by stirring at 350 rpm, heating at 50°C, and reaction for 4 hours. The particle size of this suspension was measured using LS 13320 manufactured by Beckman Coulter, Inc. (high-resolution type laser diffraction scattering particle size analyze), and it was found that the volume average particle size was 104 $\mu$m. The precipitate was separated by filtration, followed by washing with ion exchange water, drying at 60°C, and suspension polymerization, thereby obtaining a spherical phosphor A.

<Measurement using Automated Particle Shape and Particle Size Image Analyzer>

Regarding the obtained spherical phosphor A, it was found that the circularity values of 100 measurement particles were equal to or larger than 0.90, the circularity being defined by, for example, an analysis software installed on an automated particle shape and particle size image analyzer SYSMEX FPIA-3000 manufactured by Malvern Instruments Ltd.

<Measurement of Fluorescence Excitation Spectrum>

Regarding the spherical phosphor A, the excitation spectrum at a fluorescence wavelength of 621 nm was measured using a fluorescence spectrophotometer (F-4500 manufactured by Hitachi High-Technologies Corporation). The excitation spectrum is shown in FIGS. 2 and 4 along with Comparative Example described below.
It can be seen from FIGS. 2 and 4 that the excitation spectral intensity in a wavelength region 340 nm to 400 nm is 70% or higher of the excitation spectral intensity at the maximum excitation wavelength of the spherical phosphor A.

<Preparation of Resin Composition for Wavelength Conversion-type Photovoltaic Cell Sealing Material>

A mixture of 100 g of ethylene- vinyl acetate resin ULTRASEN 634 (manufactured by Tosoh Corporation) as a transparent sealing material (dispersion medium resin), 1.5 g of thermal radical initiator LUPEROX 101 (2, 5- dimethyl- 2, 5- di (t- butylperoxy) hexane, manufactured by Arkema Yoshitomi Ltd.), 0.5 g of silane coupling agent SZ6030 (3- methacryloxypropyl trimethoxysilane, manufactured by Dow Corning Corporation), and 1.0 g of the spherical phosphor A was kneaded with a roll mixer at 100°C, thereby obtaining a resin composition for a wavelength conversion- type photovoltaic cell sealing material.

<Preparation of Wavelength Conversion-type Photovoltaic Cell Sealing Material Sheet>

Approximately 30 g of the obtained resin composition for a wavelength conversion-type photovoltaic cell sealing material was interposed between release sheets and was formed into a sheet form using a stainless steel spacer having a thickness of 0.15 mm and a press in which the temperature of a heating plate was set to 80°C. This sheet was used as a light emitting layer (wavelength conversion-type photovoltaic cell sealing material). The refractive index of the sheet-like wavelength conversion-type photovoltaic cell sealing material was 1.5.
A resin composition for a sealing material was prepared in the same manner as the preparation of the resin composition for a wavelength conversion-type photovoltaic cell sealing material, except that the spherical phosphor A was not added. Then, in the same manner, this resin composition was formed into a sheet form using a stainless steel spacer having a thickness of 0.45 mm and a press in which the temperature of a heating plate was set to 80°C. This sheet was used as a support layer. The light emitting layer and the support layer were bonded into a sheet form using a press at 80°C, thereby obtaining a wavelength conversion-type photovoltaic cell sealing material sheet.

<Preparation of Photovoltaic Cell Sealing Material Sheet for Back Surface>

A resin composition for a sealing material was prepared in the same manner as above, except that the spherical phosphor was not added. Then, a photovoltaic cell sealing material sheet for a back surface was prepared in the same manner as in the preparation of the wavelength conversion-type photovoltaic cell photovoltaic cell sealing material sheet, except that the resin composition for a sealing material was used instead of the resin composition for a wavelength conversion-type photovoltaic cell sealing material.

<Preparation of Wavelength Conversion-type Photovoltaic Cell Module>

The wavelength conversion-type photovoltaic cell sealing material sheet was disposed on a tempered glass (manufactured by Asahi Glass Co., Ltd., refractive index: 1.5) as a protective glass such that the support layer faces downward and the light emitting layer faces upward. A photovoltaic cell element for extracting an electromotive force to the outside was disposed thereon such that a light receiving surfaces faces downward. Furthermore, the photovoltaic cell sealing material sheet for a back surface and a PET film (trade name: A-4300, manufactured by Toyobo Co., Ltd.) as a back film were disposed thereon. Then, laminating was performed using a vacuum laminator, thereby preparing a wavelength conversion-type photovoltaic cell module.
In the used photovoltaic cell element, a cell antireflection film having a refractive index of 1.9 was formed.

<Evaluation of Photovoltaic cell Characteristics>

A solar simulator (WXS- 1555- 10 manufactured by Wacom Electric Co., Ltd., AM 1.5G) was used as an artificial sunlight lamp. Regarding current- voltage characteristics, a short- circuit current density Jsc of a photovoltaic cell element before module sealing and a short- circuit current density Jsc thereof after module sealing were respectively measured using a I- V curve tracer (MP- 160, manufactured by Eko Instruments, Co., Ltd.), and a difference ($\triangle$Jsc) therebetween was evaluated. As a result, $\triangle$Jsc was found to be 0.66 mA/cm$^2$.

<Light Resistance Test>

The above-described wavelength conversion-type photovoltaic cell module after the evaluation of the photovoltaic cell characteristics was exposed to light with an irradiance of 60 W/m$^2$ (300 nm to 400 nm) using a 7.5 kW super xenon weather meter (SX75, manufactured by Suga Test Instruments Co., Ltd.) as a light resistance testing machine. The short-circuit current densities $\triangle$Jsc after 210 hours and after 500 hours were normalized with the initial value, and the deterioration state was recorded. The result thereof is shown in Fig. 10 along with Comparative Example 1.

(Comparative Example 1)

<Synthesis of Eu(TTA)$_3$Phen>

A solution obtained by dissolving 2.00 g (9.00 mmol) of thenoyltrifluoroacetone (TTA) in 75.0 g of ethanol was added to 11 g of an aqueous sodium hydroxide solution (1M) . Next, a solution obtained by dissolving 0.62 g (3.44 mmol) of 1, 10- phenanthroline in 75.0 g of ethanol was added thereto, followed by stirring for 1 hour. Next, a solution obtained by dissolving 1.03 g of (2.81 mmol) of europium (III) chloride hexahydrate in 20.0 g of ethanol was added dropwise, followed by stirring for 1 hour. The produced precipitate was separated by suction filtration, followed by washing with ethanol and drying, thereby obtaining Eu (TTA)$_3$Phen as a fluorescent substance.
Regarding the obtained fluorescent substance, the excitation spectrum at a fluorescence wavelength of 621 nm was measured using a fluorescence spectrophotometer (F- 4500 manufactured by Hitachi High- Technologies Corporation) and using dimethylformamide as a solvent, and it was found that the maximum excitation wavelength of the obtained fluorescent substance was 392 nm.

A spherical phosphor B was obtained in the same manner as in <Preparation of Spherical Phosphor> of Example 1, except that Eu (TTA)$_3$Phen was used as the fluorescent substance and the amount of methyl methacrylate was changed to 100 g.

Subsequently, in the same manner as above, < Measurement using Automated Particle Shape and Particle Size Image Analyzer >, <Measurement of Fluorescence Excitation Spectrum>, <Preparation of Resin Composition for Wavelength Conversion- type Photovoltaic Cell Sealing Material>, <Preparation of Wavelength Conversion- type Photovoltaic Cell Sealing Material Sheet>, <Preparation of Photovoltaic Cell Sealing Material Sheet for Back Surface>, <Preparation of Wavelength Conversion- type Photovoltaic Cell Module>, <Evaluation of Photovoltaic Cell Characteristics>, and <Light Resistance Test> were performed.

The volume average particle size of the spherical phosphor B was 104 μm and the circularity was equal to or larger than 0.90.

The excitation spectrum of the spherical phosphor B was shown in FIGS. 2 and 4 along with Example 1.

It can be seen from FIGS. 2 and 4 that the excitation spectral intensity in a wavelength region of from 340 nm to 380 nm is 38% or higher of the excitation spectral intensity at the maximum excitation wavelength of the spherical phosphor B, and that there is a wavelength region in which the intensity is 50% or lower.

In addition, ΔJsc was 0.46 mA/cm$^2$.

The result of the light resistance test is shown in Fig. 10 along with Example 1.

The light utilization efficiency of a photovoltaic cell module can be improved and the power generation efficiency can be stably improved by configuring the photovoltaic cell module using the wavelength conversion-type photovoltaic cell sealing material which includes the spherical phosphor according to the present invention. Furthermore, in the light resistance test, deterioration can be reduced as compared to the phosphor of the related art.

The entire contents of the disclosure of Japanese Patent Application No. 2010-271386 are incorporated by reference herein.

All publications, patent applications, and technical standards described in this specification are herein incorporated by reference to the same extent as if each individual publication, patent application, or technical standard was specifically and individually indicated to be incorporated by reference.

**Claims**

1. A spherical phosphor comprising:

   a fluorescent substance having a maximum excitation wavelength of 400 nm or longer; and
   a transparent material comprising the fluorescent substance,
   wherein, in an excitation spectrum, an excitation spectral intensity in a wavelength region of from 340 nm to 380 nm is 50% or higher of an excitation spectral intensity at a maximum excitation wavelength.

2. The spherical phosphor according to claim 1, wherein the fluorescent substance comprises a rare earth metal complex.

3. The spherical phosphor according to claim 1 or 2, wherein the fluorescent substance comprises a europium complex.

4. The spherical phosphor according to any one of claims 1 to 3, wherein the transparent material comprises a transparent resin.

5. The spherical phosphor according to any one of claims 1 to 4, wherein the transparent material comprises a transparent vinyl resin.

6. The spherical phosphor according to any one of claims 1 to 5, wherein the transparent material comprises a (meth)acrylic resin.

7. The spherical phosphor according to any one of claims 1 to 6, wherein a refractive index of the transparent material is equal to or larger than 1.4 and is smaller than a refractive index of the fluorescent substance.

8. The spherical phosphor according to any one of claims 5 to 7, which is an emulsion polymerization product or a suspension polymerization product of a vinyl monomer composition comprising the fluorescent substance and a vinyl monomer.

9. The spherical phosphor according to any one of claims 5 to 8, which is a suspension polymerization product of a vinyl monomer composition containing the fluorescent substance and a vinyl monomer.

10. A wavelength conversion-type photovoltaic cell sealing material comprising:

    a light-permeable resin composition layer which comprises the spherical phosphor according to any one of claims 1 to 9 and a sealing resin.

**11.** The wavelength conversion-type photovoltaic cell sealing material according to claim 10, wherein a content of the spherical phosphor in the resin composition layer is from 0.0001% by mass to 10% by mass.

**12.** The wavelength conversion-type photovoltaic cell sealing material according to claim 10 or 11, further comprising a light-permeable layer other than the resin composition layer.

**13.** The wavelength conversion-type photovoltaic cell sealing material according to claim 12, comprising:

the resin composition layer; and
a number, m, of light-permeable layers other than the resin composition layer, wherein, given that refractive indices of the m layers are represented by $n_1$, $n_2$, ..., $n_{(m-1)}$, and $n_m$ in this order from a light incident side, the following expression is satisfied: $n_1 \leq n_2 \leq ... \leq n_{(m-1)} \leq n_m$.

**14.** A photovoltaic cell module comprising:

a photovoltaic cell element; and
the wavelength conversion-type photovoltaic cell sealing material according to any one of claims 10 to 13, disposed on a light receiving surface of the photovoltaic cell element.

**15.** A method of producing the wavelength conversion-type photovoltaic cell sealing material according to any one of claims 10 to 13, the method comprising:

preparing the spherical phosphor according to any one of claims 1 to 9;
mixing or dispersing the spherical phosphor with or in a sealing resin to prepare a resin composition; and
forming the resin composition into a sheet form to prepare a light-permeable resin composition layer.

**16.** A method of manufacturing a photovoltaic cell module, comprising:

preparing the wavelength conversion-type photovoltaic cell sealing material according to any one of claims 10 to 13; and
disposing the wavelength conversion-type photovoltaic cell sealing material on a light receiving surface of a photovoltaic cell element.

FIG. 1

EP 2 650 342 A1

# FIG. 2

EP 2 650 342 A1

# FIG. 3

EP 2 650 342 A1

# FIG. 4

Legend:

— EXCITATION SPECTRUM OF FLUORESCENT SUBSTANCE OF EXAMPLE 1
— · EXCITATION SPECTRUM OF SPHERICAL PHOSPHOR OF EXAMPLE 1
—— EXCITATION SPECTRUM OF FLUORESCENT SUBSTANCE OF COMPARATIVE EXAMPLE 1
– – – EXCITATION SPECTRUM OF SPHERICAL PHOSPHOR OF COMPARATIVE EXAMPLE 1
— – · SPECTRUM OF EVA-LIGHT RESISTANCE TEST BEFORE INTRODUCTION
— · · SPECTRUM OF EVA-LIGHT RESISTANCE TEST AFTER 696 H
········· SPECTRUM OF ULTRAVIOLET ABSORBER
– – · SOLAR SPECTRUM (AM 1.5)
▬ – SPECTRAL SENSITIVITY OF CRYSTALLINE SILICON PHOTOVOLTAIC CELL

Graph labels:
- SOLAR SPECTRUM (AM 1.5)
- SPECTRUM OF ULTRAVIOLET ABSORBER
- SPECTRAL SENSITIVITY OF CRYSTALLINE SILICON PHOTOVOLTAIC CELL
- Y-axis: INTENSITY [ARBITRARY SCALE]
- X-axis: WAVELENGTH [nm]

# FIG. 5

$n_1 < n_2$

$n_1$

$n_2$

CRITICAL ANGLE

$$\theta_c = \sin^{-1}(n_1/n_2)$$

# FIG. 6

EXCITATION LIGHT     EMITTED LIGHT

n

$\lambda$ (nm)

WAVELENGTH DISPERSION
OF REFRACTIVE INDEX

FIG. 7

FIG. 8

# FIG. 9

# FIG. 10

<table>
<tr><td colspan="3">**INTERNATIONAL SEARCH REPORT**</td><td>International application No.<br>PCT/JP2011/076708</td></tr>
</table>

A. CLASSIFICATION OF SUBJECT MATTER
*C09K11/06*(2006.01)i, *C08K5/00*(2006.01)i, *C08L33/06*(2006.01)i, *H01L31/042*
(2006.01)i

According to International Patent Classification (IPC) or to both national classification and IPC

B. FIELDS SEARCHED

Minimum documentation searched (classification system followed by classification symbols)
C09K11/06, C08L33/06, H01L31/042

Documentation searched other than minimum documentation to the extent that such documents are included in the fields searched
Jitsuyo Shinan Koho      1922–1996   Jitsuyo Shinan Toroku Koho   1996–2012
Kokai Jitsuyo Shinan Koho  1971–2012   Toroku Jitsuyo Shinan Koho   1994–2012

Electronic data base consulted during the international search (name of data base and, where practicable, search terms used)
CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| A | WO 2010/001703 A1 (Hitachi Chemical Co., Ltd.), 07 January 2010 (07.01.2010), claims; examples; paragraph [0057] & JP 2010-34502 A | 1-16 |
| A | JP 2005-082647 A (Teijin Chemicals Ltd.), 31 March 2005 (31.03.2005), paragraph [0062] (Family: none) | 1-16 |
| A | JP 2010-258439 A (Japan Polyethylene Corp.), 11 November 2010 (11.11.2010), claims; paragraph [0047] & WO 2010/114028 A1 | 1-16 |

☒ Further documents are listed in the continuation of Box C.   ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

Date of the actual completion of the international search
09 February, 2012 (09.02.12)

Date of mailing of the international search report
21 February, 2012 (21.02.12)

Name and mailing address of the ISA/
Japanese Patent Office

Authorized officer

Facsimile No.

Telephone No.

Form PCT/ISA/210 (second sheet) (July 2009)

30

**INTERNATIONAL SEARCH REPORT**

| International application No. |
| --- |
| PCT/JP2011/076708 |

C (Continuation). DOCUMENTS CONSIDERED TO BE RELEVANT

| Category* | Citation of document, with indication, where appropriate, of the relevant passages | Relevant to claim No. |
| --- | --- | --- |
| A | JP 2010-155915 A (Japan Polyethylene Corp.), 15 July 2010 (15.07.2010), claims; paragraph [0047] (Family: none) | 1-16 |
| A | JP 2009-013186 A (Mitsubishi Chemical Corp.), 22 January 2009 (22.01.2009), claims; paragraph [0018] (Family: none) | 1-16 |
| A | JP 2007-308548 A (Yamaguchi University), 29 November 2007 (29.11.2007), claims; examples (Family: none) | 1-16 |
| A | Youyi Sun et al., High luminescence quantum yields and long luminescence lifetime from Eu(III) complex containing two crystal water based on a new $\beta$-diketonate ligand, Spectrochimica Acta, Part A, 2006, vol.64A, No.4, pp.977-980 | 1-16 |
| A | JP 2009-046577 A (Toshiba Corp.), 05 March 2009 (05.03.2009), claims; examples (Family: none) | 1-16 |
| P,A | WO 2011/040391 A1 (Hitachi Chemical Co., Ltd.), 07 April 2011 (07.04.2011), claims; examples & TW 2011-20188 A1 | 1-16 |
| P,A | WO 2011/126118 A1 (Hitachi Chemical Co., Ltd.), 13 October 2011 (13.10.2011), claims; examples (Family: none) | 1-16 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003218379 A
- JP 2006303033 A
- JP 2003051605 A
- JP 2010085483 A
- JP 2010260326 A
- JP 2010271386 A

**Non-patent literature cited in the description**

- **MASAYA MITSUISHI ; SHINJI KIKUCHI ; TOKUJI MIYASHITA ; YUTAKA AMANO.** *J.Mater.Chem.,* 2003, vol. 13, 285-2879